(19) Europäisches Patentamt
European Patent Office
Office européen des brevets

(11) EP 3 904 486 B1

(12) **EUROPEAN PATENT SPECIFICATION**

(45) Date of publication and mention of the grant of the patent:
**10.12.2025 Bulletin 2025/50**

(21) Application number: **19902600.6**

(22) Date of filing: **06.12.2019**

(51) International Patent Classification (IPC):
***C09K 11/06*** *(2006.01)* ***C09K 11/02*** *(2006.01)*
***H10K 71/00*** *(2023.01)* ***H10K 85/00*** *(2023.01)*
***H10K 85/60*** *(2023.01)*

(52) Cooperative Patent Classification (CPC):
**C09K 11/06; C09K 11/02; H10K 71/311; H10K 85/00; H10K 85/615; H10K 85/626; H10K 85/654; H10K 85/6572;** C09K 2211/1011; C09K 2211/1044; C09K 2211/1059; H10K 50/11

(86) International application number:
**PCT/JP2019/047806**

(87) International publication number:
**WO 2020/137448 (02.07.2020 Gazette 2020/27)**

(54) **COMPOSITION FOR LUMINESCENT ELEMENT, AND LUMINESCENT ELEMENT CONTAINING SAME**

ZUSAMMENSETZUNG FÜR EIN LUMINESZIERENDES ELEMENT UND LUMINESZIERENDES ELEMENT DAMIT

COMPOSITION POUR ÉLÉMENT LUMINESCENT ET ÉLÉMENT LUMINESCENT LA CONTENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.12.2018 JP 2018247672**

(43) Date of publication of application:
**03.11.2021 Bulletin 2021/44**

(73) Proprietor: **SUMITOMO CHEMICAL COMPANY, LIMITED**
**Chuo-ku**
**Tokyo 104-8260 (JP)**

(72) Inventors:
- **SASADA, Toshiaki**
**Tsukuba-shi, Ibaraki 300-3294 (JP)**
- **MATSUMOTO, Ryuji**
**Tsukuba-shi, Ibaraki 300-3294 (JP)**

(74) Representative: **J A Kemp LLP**
**80 Turnmill Street**
**London EC1M 5QU (GB)**

(56) References cited:
**EP-A1- 2 301 983**
**WO-A1-2014/092083**
**WO-A1-2017/130977**
**WO-A1-2018/061421**
**JP-A- 2005 041 982**
**JP-A- 2008 516 421**
**JP-A- 2017 183 724**
**JP-A- 2017 183 724**
**US-A1- 2008 113 468**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 904 486 B1

## Description

Technical Field

The present invention relates to a composition for light emitting device and a light emitting device containing the same.

Background Art

Light emitting devices such as an organic electroluminescent device and the like can be suitably used, for example, for display and illumination. For example, Patent Document 1 suggests a composition containing a compound H0 and a heterocyclic compound, as the material used for light emitting devices.

[Chemical Formula 1a]

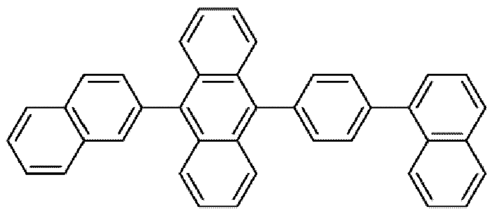

compound H0

Patent Document 2 relates to a polymer compound comprising a residue of a compound of formula (0):

[Chemical Formula 1b]

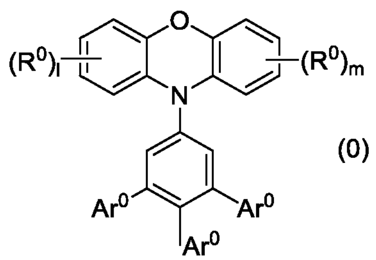

(0)

(wherein $Ar^0$ represents a substituent such as a hydrogen atom, an alkyl group, an alkoxy group, an aryl group and the like, or a group represented by the following formula (A). At least two $Ar^0$s are groups represented by the following formula (A). $R^0$ represents a substituent such as an alkyl group, an alkoxy group, an aryl group and the like. 1 and m represent an integer of 0 to 3.)

[Chemical Formula 1c]

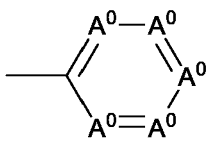

(A)

(wherein $Ar^0$ represents -N= or $-C(R^2)=$. $R^2$ represents a substituent such as a hydrogen atom, an alkyl group, an alkoxy group, an aryl group and the like.).

Patent Document 3 relates to electronic devices comprising organic semiconductors whose content of halogens is less than 20 ppm, corresponding organic semiconductors and to a process for their production.

Prior Art Document

Patent Document

Patent Document 1: Japanese Unexamined Patent Application Publication (JP-A) No. 2017-183724
Patent document 2: EP 2301983
Patent Document 3: US 2008/113468

Summary of the Invention

Problem to be Solved by the Invention

However, the light emitting device fabricated using the above-described composition was not necessarily sufficient in suppression of initial deterioration.

Then, the present invention has an object of providing a composition which is useful for production of a light emitting device of which initial deterioration is suppressed, and a light emitting device formed using the composition.

Means for Solving the Problem

The present inventors have intensively studied to solve the above-described problem and resultantly found that a silicon atom exerts a significant influence on the initial deterioration of a light emitting device having an organic layer containing a specific composition, and further found that the initial deterioration of the light emitting device can be suppressed by setting the amount of silicon atoms in a specific range, leading to completion of the present invention. Patent Document 1 does not describe that the amount of silicon atoms contained in a composition influences the initial deterioration of a light emitting device.

That is, the present invention provides the following [1] to [14].

[1] A composition for light emitting device containing a host material and a guest material blended therein, wherein

the above-described host material contains an aromatic compound having a condensed ring skeleton in which only three or more benzene rings are condensed,
the above-described guest material contains a compound having a heterocyclic group containing a carbon atom and at least one selected from the group consisting of a boron atom, a nitrogen atom, a phosphorus atom, an oxygen atom, a sulfur atom and a selenium atom in the ring, and
the total amount of silicon atoms contained in the above-described host material and silicon atoms contained in the above-described guest material is 7 ppm by mass or more and 28 ppm by mass or less with respect to the total amount of the above-described host material and the above-described guest material , and wherein:

(a) the above-described aromatic compound having a condensed ring skeleton in which only three or more benzene rings are condensed is a compound represented by the formula (FH):

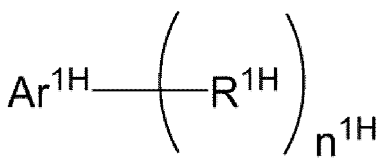

(FH)

wherein,

$n^{1H}$ represents an integer of 0 or more,
$Ar^{1H}$ represents a group obtained by removing from an aromatic hydrocarbon having a condensed ring skeleton in which only three or more benzene rings are condensed $n^{1H}$ or more hydrogen atoms bonding directly to carbon atoms constituting said condensed ring skeleton, and this group optionally has a substituent, when a plurality of the substituents are present, they may be the same or different and may be combined together to form a ring together with atoms to which they are attached,
$R^{1H}$ represents an aryl group or a monovalent heterocyclic group, and these groups optionally have a substituent, when a plurality of the substituents are present, they may be the same or different and may be combined together to form a ring together with atoms to which they are attached, when a plurality of

$R^{1H}$ are present, they may be the same or different and may be combined together to form a ring together with atoms to which they are attached; and

(b) the above-described compound having the heterocyclic group is a compound represented by the formula (FB):

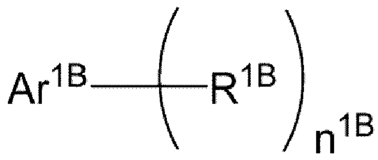

(FB)

wherein,

$n^{1B}$ represents an integer of 0 or more.
$Ar^{1B}$ represents a group obtained by removing from a compound having a heterocyclic ring containing a carbon atom and at least one selected from the group consisting of a boron atom, a nitrogen atom, a phosphorus atom, an oxygen atom, a sulfur atom and a selenium atom in the ring $n^{1B}$ or more hydrogen atoms bonding directly to atoms constituting the above-described heterocyclic ring, and this group optionally has a substituent, when a plurality of the substituents are present, they may be the same or different and may be combined together to form a ring together with atoms to which they are attached.
$R^{1B}$ represents a halogen atom, an alkyl group, a cycloalkyl group, an alkoxy group, a cycloalkoxy group, an aryloxy group, an aryl group, a monovalent heterocyclic group or a substituted amino group, and these groups optionally have a substituent, when a plurality of the substituents are present, they may be the same or different and may be combined together to form a ring together with atoms to which they are attached, when a plurality of $R^{1B}$ are present, they may be the same or different and may be combined together to form a ring together with atoms to which they are attached.

[2] The composition for light emitting device according to [1], wherein the above-described condensed ring skeleton is a condensed ring skeleton in which only three or more and five or less benzene rings are condensed.
[3] The composition for light emitting device according to [2], wherein the above-described condensed ring skeleton is an anthracene skeleton, a phenanthrene skeleton, a benzoanthracene skeleton, a benzophenanthrene skeleton or a pyrene skeleton.
[4] The composition for light emitting device according to any one of [1] to [3], wherein the above-described heterocyclic group is a heterocyclic group containing a carbon atom and a nitrogen atom in the ring.
[5] The composition for light emitting device according to any one of [1] to [4], wherein the above-described heterocyclic group is a heterocyclic group obtained by removing from a monocyclic or bicyclic to pentacyclic heterocyclic compound one or more hydrogen atoms bonding directly to atoms constituting the ring.
[6] The composition for light emitting device according to any one of [1] to [5], wherein
the above-described heterocyclic group is a heterocyclic group obtained by removing from pyridine, diazabenzene, triazine, carbazole, dibenzofuran, dibenzothiophene, benzocarbazole, dibenzocarbazole, indolocarbazole or indenocarbazole one or more hydrogen atoms bonding directly to atoms constituting the ring.
[7] The composition for light emitting device according to any one of [1] to [6], further containing at least one selected from the group consisting of a hole transporting material, a hole injection material, an electron transporting material, an electron injection material, a light emitting material, an antioxidant and a solvent.
[8] A light emitting device having an anode, a cathode, and an organic layer disposed between the above-described anode and the above-described cathode, wherein
the above-described organic layer is a layer containing the composition for light emitting device as described in any one of [1] to [7].
[9] A method for producing a composition for light emitting device containing a host material and a guest material blended therein, comprising

a host material preparation step of preparing a host material containing an aromatic compound having a condensed ring skeleton in which only three or more benzene rings are condensed,
a guest material preparation step of preparing a guest material containing a compound having a heterocyclic group containing a carbon atom and at least one selected from the group consisting of a boron atom, a nitrogen atom, a phosphorus atom, an oxygen atom, a sulfur atom and a selenium atom in the ring, and
a production step of mixing the above-described host material and the above-described guest material at a

blending ratio such that the total amount of silicon atoms contained in the above-described host material and silicon atoms contained in the above-described guest material is 7 ppm or more by mass and 28 ppm by mass or less to obtain a composition for light emitting device; and

(a) the above-described aromatic compound having a condensed ring skeleton in which only three or more benzene rings are condensed is a compound represented by the formula (FH):

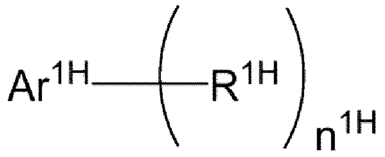 (FH)

wherein,

$n^{1H}$ represents an integer of 0 or more,
$Ar^{1H}$ represents a group obtained by removing from an aromatic hydrocarbon having a condensed ring skeleton in which only three or more benzene rings are condensed $n^{1H}$ or more hydrogen atoms bonding directly to carbon atoms constituting said condensed ring skeleton, and this group optionally has a substituent, when a plurality of the substituents are present, they may be the same or different and may be combined together to form a ring together with atoms to which they are attached,
$R^{1H}$ represents an aryl group or a monovalent heterocyclic group, and these groups optionally have a substituent, when a plurality of the substituents are present, they may be the same or different and may be combined together to form a ring together with atoms to which they are attached, when a plurality of $R^{1H}$ are present, they may be the same or different and may be combined together to form a ring together with atoms to which they are attached; and

(b) the above-described compound having the heterocyclic group is a compound represented by the formula (FB):

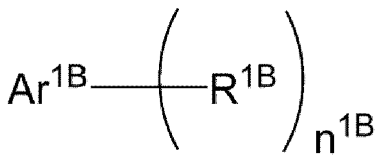 (FB)

wherein,

$n^{1B}$ represents an integer of 0 or more.
$Ar^{1B}$ represents a group obtained by removing from a compound having a heterocyclic ring containing a carbon atom and at least one selected from the group consisting of a boron atom, a nitrogen atom, a phosphorus atom, an oxygen atom, a sulfur atom and a selenium atom in the ring $n^{1B}$ or more hydrogen atoms bonding directly to atoms constituting the above-described heterocyclic ring, and this group optionally has a substituent, when a plurality of the substituents are present, they may be the same or different and may be combined together to form a ring together with atoms to which they are attached.
$R^{1B}$ represents a halogen atom, an alkyl group, a cycloalkyl group, an alkoxy group, a cycloalkoxy group, an aryloxy group, an aryl group, a monovalent heterocyclic group or a substituted amino group, and these groups optionally have a substituent, when a plurality of the substituents are present, they may be the same or different and may be combined together to form a ring together with atoms to which they are attached, when a plurality of $R^{1B}$ are present, they may be the same or different and may be combined together to form a ring together with atoms to which they are attached.

[10] The production method according to [9], wherein
the above-described host material preparation step comprises

a step (A-1) of preparing the above-described aromatic compound having a condensed ring skeleton in which only three or more benzene rings are condensed containing silicon atoms mixed therein, and
a step (A-2) of purifying at least a part of the above-described aromatic compound having a condensed ring

skeleton in which only three or more benzene rings are condensed prepared in the above-described step (A-1) to remove at least a part of the above-described silicon atoms.

[11] The production method according to [9] or [10], wherein
the above-described guest material preparation step comprises

a preparation step (B-1) of preparing the above-described compound having the heterocyclic group containing silicon atoms mixed therein, and
a step (B-2) of purifying at least a part of the above-described compound having the heterocyclic group prepared in the above-described step (B-1) to remove at least a part of the above-described silicon atoms.

[12] A method for producing a composition for light emitting device containing a host material and a guest material blended therein, comprising:

(a) a host material preparation step of preparing a host material containing an aromatic compound having a condensed ring skeleton in which only three or more benzene rings are condensed,

a determination step of determining the blending ratio of the guest material to the above-described host material,
a guest material preparation step of preparing a guest material which contains a compound having a heterocyclic group containing a carbon atom and at least one selected from the group consisting of a boron atom, a nitrogen atom, a phosphorus atom, an oxygen atom, a sulfur atom and a selenium atom in the ring and with which, when mixed with the above-described host material at the above-described blending ratio, the total amount of silicon atoms contained in the above-described host material and silicon atoms contained in the above-described guest material with respect to the total amount of the above-described host material and the above-described guest material is 7 ppm by mass or more and 28 ppm by mass or less, and
a production step of mixing the above-described host material and the above-described guest material at the above-described blending ratio to obtain a composition for light emitting device; or

(b) a guest material preparation step of preparing a guest material containing a compound having a heterocyclic group containing a carbon atom and at least one selected from the group consisting of a boron atom, a nitrogen atom, a phosphorus atom, an oxygen atom, a sulfur atom and a selenium atom in the ring,

a determination step of determining the blending ratio of the host material to the above-described guest material,
a host material preparation step of preparing a host material which contains an aromatic compound having a condensed ring skeleton in which only three or more benzene rings are condensed and with which, when mixed with the above-described guest material at the above-described blending ratio, the total amount of silicon atoms contained in the above-described host material and silicon atoms contained in the above-described guest material with respect to the total amount of the above-described host material and the above-described guest material is 7 ppm by mass or more and 28 ppm by mass or less, and
a production step of mixing the above-described guest material and the above-described host material at the above-described blending ratio to obtain a composition for light emitting device; or

(c)a host material preparation step of preparing an aromatic compound having a condensed ring skeleton in which only three or more benzene rings are condensed as the host material,

a guest material preparation step of preparing a compound having a heterocyclic group containing a carbon atom and at least one selected from the group consisting of a boron atom, a nitrogen atom, a phosphorus atom, an oxygen atom, a sulfur atom and a selenium atom in the ring as the guest material,
a determination step of determining the blending ratio of the above-described host material and the above-described guest material,
a purification step of purifying at least a part of the above-described aromatic compound having a condensed ring skeleton in which only three or more benzene rings are condensed and the above-described compound having the heterocyclic group such that when the above-described host material and the above-described guest material are mixed at the above-described blending ratio, the total amount of silicon atoms contained in the above-described host material and silicon atoms contained in the above-described guest material with respect to the total amount of the above-described host material and the above-described guest material is 7

ppm by mass or more and 28 ppm by mass or less, and

a production step of mixing the above-described host material containing the above-described aromatic compound having a condensed ring skeleton in which only three or more benzene rings are condensed and the above-described guest material containing the above-described compound having the heterocyclic group at the above-described blending ratio to obtain a composition for light emitting device; wherein, for each of the above (a) to (c),

(i) said aromatic compound having a condensed ring skeleton in which only three or more benzene rings are condensed is a compound represented by the formula (FH) :

$$Ar^{1H}-\left(R^{1H}\right)_{n^{1H}} \quad \text{(FH)}$$

wherein,

$n^{1H}$ represents an integer of 0 or more,

$Ar^{1H}$ represents a group obtained by removing from an aromatic hydrocarbon having a condensed ring skeleton in which only three or more benzene rings are condensed $n^{1H}$ or more hydrogen atoms bonding directly to carbon atoms constituting said condensed ring skeleton, and this group optionally has a substituent, when a plurality of the substituents are present, they may be the same or different and may be combined together to form a ring together with atoms to which they are attached,

$R^{1H}$ represents an aryl group or a monovalent heterocyclic group, and these groups optionally have a substituent, when a plurality of the substituents are present, they may be the same or different and may be combined together to form a ring together with atoms to which they are attached, when a plurality of $R^{1H}$ are present, they may be the same or different and may be combined together to form a ring together with atoms to which they are attached; and

(ii) said compound having the heterocyclic group is a compound represented by the formula (FB):

$$Ar^{1B}-\left(R^{1B}\right)_{n^{1B}} \quad \text{(FB)}$$

wherein,

$n^{1B}$ represents an integer of 0 or more.

$Ar^{1B}$ represents a group obtained by removing from a compound having a heterocyclic ring containing a carbon atom and at least one selected from the group consisting of a boron atom, a nitrogen atom, a phosphorus atom, an oxygen atom, a sulfur atom and a selenium atom in the ring $n^{1B}$ or more hydrogen atoms bonding directly to atoms constituting the above-described heterocyclic ring, and this group optionally has a substituent, when a plurality of the substituents are present, they may be the same or different and may be combined together to form a ring together with atoms to which they are attached.

$R^{1B}$ represents a halogen atom, an alkyl group, a cycloalkyl group, an alkoxy group, a cycloalkoxy group, an aryloxy group, an aryl group, a monovalent heterocyclic group or a substituted amino group, and these groups optionally have a substituent, when a plurality of the substituents are present, they may be the same or different and may be combined together to form a ring together with atoms to which they are attached, when a plurality of $R^{1B}$ are present, they may be the same or different and may be combined together to form a ring together with atoms to which they are attached.

[13] The production method according to any one of [9] to [12], further comprising

a host material measurement step of measuring the content of silicon atoms contained in the above-described aromatic compound having a condensed ring skeleton in which only three or more benzene rings are condensed,

and

a guest material measurement step of measuring the content of silicon atoms contained in the above-described compound having a heterocyclic group containing a carbon atom and at least one selected from the group consisting of a boron atom, a nitrogen atom, a phosphorus atom, an oxygen atom, a sulfur atom and a selenium atom in the ring.

[14] A method for producing a light emitting device containing an anode, a cathode, and an organic layer disposed between the above-described anode and the above-described cathode, comprising
a step of forming the above-described organic layer with the composition for light emitting device produced by the production method as described in any one of [9] to [13].

Effect of the Invention

According to the present invention, a composition which is useful for production of a light emitting device of which initial deterioration is suppressed can be provided. In addition, according to the present invention, a light emitting device containing the above-described composition can be provided. Further, according to the present invention, methods for producing the above-described composition and the above-described light emitting device can be provided.

Modes for Carrying Out the Invention

Suitable embodiments of the present embodiment will be illustrated in detail below.

<Explanation of common term>

The terms commonly used in the present specification have the following meanings unless otherwise stated.
"Room temperature" means 25°C.
Me represents a methyl group, Et represents an ethyl group, Bu represents a butyl group, i-Pr represents an isopropyl group, and t-Bu represents a tert-butyl group.
The hydrogen atom may be a heavy hydrogen atom or a light hydrogen atom.
"The polymer compound" means a polymer having molecular weight distribution and having a polystyrene-equivalent number-average molecular weight of $1\times10^3$ to $1\times10^8$.
"The low-molecular compound" means a compound having no molecular weight distribution and having a molecular weight of $1\times10^4$ or less.
"The constitutional unit" means a unit occurring once or more times in a polymer compound.
"The alkyl group" may be any of linear and branched. The number of carbon atoms of the linear alkyl group, not including the number of carbon atoms of the substituent, is usually 1 to 50, preferably 1 to 20 and more preferably 1 to 10. The number of carbon atoms of the branched alkyl group, not including the number of carbon atoms of the substituent, is usually 3 to 50, preferably 3 to 20 and more preferably 4 to 10. The alkyl group optionally has a substituent and examples thereof include a methyl group, an ethyl group, an isopropyl group, a butyl group, an isobutyl group, a tert-butyl group, a pentyl group, a hexyl group, a heptyl group, an octyl group, a 2-ethylhexyl group, a decyl group, a 3,7-dimethyloctyl group, a 2-ethyloctyl group, a dodecyl group, a trifluoromethyl group, a 3-phenylpropyl group, a 3-(4-methylphenyl)propyl group, a 3-(3,5-dihexylphenyl)propyl group and a 6-ethyloxyhexyl group.
The number of carbon atoms of "the cycloalkyl group", not including the number of carbon atoms of the substituent, is usually 3 to 50, and preferably 4 to 10. The cycloalkyl group optionally has a substituent and examples thereof include a cyclohexyl group and a methylcyclohexyl group.
The number of carbon atoms of "the alkylene group", not including the number of carbon atoms of the substituent, is usually 1 or more and 20 or less, preferably 1 or more and 15 or less and more preferably 1 or more and 10 or less. The alkylene group optionally has a substituent and examples thereof include a methylene group, an ethylene group, a propylene group, a butylene group, a hexylene group and an octylene group.
The number of carbon atoms of "the cycloalkylene group", not including the number of carbon atoms of the substituent, is usually 3 or more and 20 or less. The cycloalkylene group optionally has a substituent and examples thereof include a cyclohexylene group.
"The aromatic hydrocarbon group" means a group obtained by removing from an aromatic hydrocarbon one or more hydrogen atoms bonding directly to carbon atoms constituting the ring. The group obtained by removing from an aromatic hydrocarbon one hydrogen atom bonding directly to a carbon atom constituting the ring is referred to also as "aryl group". The group obtained by removing from an aromatic hydrocarbon two hydrogen atoms bonding directly to carbon atoms constituting the ring is referred to also as "arylene group".
The number of carbon atoms of the aromatic hydrocarbon group, not including the number of carbon atoms of the

substituent, is usually 6 to 60, preferably 6 to 30 and more preferably 6 to 18.

"The aromatic hydrocarbon group" includes, for example, groups obtained by removing from a monocyclic aromatic hydrocarbon (including, for example, benzene) or a polycyclic aromatic hydrocarbon (including, for example, bicyclic aromatic hydrocarbons such as naphthalene and indene and the like; tricyclic aromatic hydrocarbons such as anthracene, phenanthrene, dihydrophenanthrene and fluorene and the like; tetracyclic aromatic hydrocarbons such as benzoanthracene, benzophenanthrene, benzofluorene, pyrene and fluoranthene and the like; pentacyclic aromatic hydrocarbons such as dibenzoanthracene, dibenzophenanthrene, dibenzofluorene, perylene and benzofluoranthene and the like; hexacyclic aromatic hydrocarbons such as spirobifluorene and the like; and heptacyclic aromatic hydrocarbons such as benzospirobifluorene and acenaphthofluoranthene and the like) one or more hydrogen atoms bonding directly to carbon atoms constituting the ring, and these groups optionally have a substituent. The aromatic hydrocarbon group includes groups obtained by bonding a plurality of these groups.

"The alkoxy group" may be any of linear and branched. The number of carbon atoms of the linear alkoxy group, not including the number of carbon atoms of the substituent, is usually 1 to 40, and preferably 1 to 10. The number of carbon atoms of the branched alkoxy group, not including the number of carbon atoms of the substituent, is usually 3 to 40, and preferably 4 to 10. The alkoxy group optionally has a substituent and examples thereof include a methoxy group, an ethoxy group, an isopropyloxy group, a butyloxy group, a hexyloxy group, a 2-ethylhexyloxy group, a 3,7-dimethyloctyloxy group and a lauryloxy.

The number of carbon atoms of "the cycloalkoxy group", not including the number of carbon atoms of the substituent, is usually 3 to 40, and preferably 4 to 10. The cycloalkoxy group optionally has a substituent and examples thereof include a cyclohexyloxy group.

The number of carbon atoms of "the aryloxy group", not including the number of carbon atoms of the substituent, is usually 6 to 60, and preferably 6 to 48. The aryloxy group optionally has a substituent and examples thereof include a phenoxy group, a naphthyloxy group, an anthracenyloxy group and a pyrenyloxy group.

"The heterocyclic group" means a group obtained by removing from the heterocyclic compound one or more hydrogen atoms bonding directly to carbon atoms or hetero atoms constituting the ring. Of the heterocyclic groups, "aromatic heterocyclic group" which is a group obtained by removing from the aromatic heterocyclic compound one or more hydrogen atoms bonding directly to carbon atoms or hetero atoms constituting the ring is preferable. The group obtained by removing from a heterocyclic compound p hydrogen atoms (p represents an integer of 1 or more) bonding directly to carbon atoms or hetero atoms constituting the ring is referred to also as "p-valent heterocyclic group". The group obtained by removing from an aromatic heterocyclic compound p hydrogen atoms bonding directly to carbon atoms or hetero atoms constituting the ring is referred to also as "p-valent aromatic heterocyclic group".

"The aromatic heterocyclic compound" includes, for example, compounds of which heterocyclic ring itself shows aromaticity such as azole, thiophene, furan, pyridine, diazabenzene, triazine, azanaphthalene, diazanaphthalene and carbazole and the like, and compounds in which an aromatic ring is condensed to the heterocyclic ring even if the heterocyclic ring itself shows no aromaticity such as phenoxazine, phenothiazine and benzopyran and the like.

The number of carbon atoms of the heterocyclic group, not including the number of carbon atoms of the substituent, is usually 1 to 60, preferably 2 to 40, and more preferably 3 to 20. The number of hetero atoms of the heterocyclic group, not including the number of carbon atoms of the substituent, is usually 1 to 30, preferably 1 to 10 and more preferably 1 to 3.

The heterocyclic group optionally has a substituent and examples thereof include groups obtained by removing from a monocyclic heterocyclic compound (including, for example, furan, thiophene, oxadiazole, pyrrole, diazole, triazole, tetrazole, pyridine, diazabenzene and triazine) or a polycyclic heterocyclic compound (including, for example, bicyclic heterocyclic compounds such as azanaphthalene, diazanaphthalene, benzofuran, benzothiophene, indole, benzodiazole and benzothiadiazole and the like; tricyclic heterocyclic compounds such as dibenzofuran, dibenzothiophene, dibenzoborole, dibenzosilole, dibenzophophole, dibenzoselenophene, carbazole, azacarbazole, diazacarbazole, phenoxazine, phenothiazine, 9,10-dihydroacridine, 5,10-dihydrophenazine, phenazaboline, phenophosphazine, phenoselanazine, phenazasiline, azaanthracene, diazaanthracene, azaphenanthrene and diazaphenanthrene and the like; tetracyclic heterocyclic compounds such as hexaazatriphenylene, benzocarbazole, benzonaphthofuran and benzonaphthothiophene and the like; pentacyclic heterocyclic compounds such as dibenzocarbazole, indolocarbazole and indenocarbazole and the like; hexacyclic heterocyclic compounds such as carbazolocarbazole, benzoindolocarbazole and benzoindenocarbazole and the like; and heptacyclic heterocyclic compounds such as dibenzoindolocarbazole and the like) one or more hydrogen atoms bonding directly to atoms constituting the ring, and these groups optionally have a substituent. The heterocyclic group includes groups obtained by bonding a plurality of these groups.

"The halogen atom" denotes a fluorine atom, a chlorine atom, a bromine atom or an iodine atom.

"The amino group" optionally has a substituent, with substituted amino groups (namely, secondary amino groups or tertiary amino groups, preferably tertiary amino groups) being preferred. As the substituent which an amino group has, an alkyl group, a cycloalkyl group, an aryl group or a monovalent heterocyclic group is preferable. When a plurality of the substituents which an amino group has are present, they may be the same or different and may be combined together to

form a ring together with nitrogen atoms to which they are attached.

The substituted amino group includes, for example, a dialkylamino group, a dicycloalkylamino group and a diarylamino group.

The amino group includes, for example, a dimethylamino group, a diethylamino group, a diphenylamino group, a bis(methylphenyl)amino group and a bis(3,5-di-tert-butylphenyl)amino group.

"The alkenyl group" may be any of linear and branched. The number of carbon atoms of the linear alkenyl group, not including the number of carbon atoms of the substituent, is usually 2 to 30, and preferably 3 to 20. The number of carbon atoms of the branched alkenyl group, not including the number of carbon atoms of the substituent, is usually 3 to 30, and preferably 4 to 20.

The number of carbon atoms of "the cycloalkenyl group", not including the number of carbon atoms of the substituent, is usually 3 to 30, and preferably 4 to 20.

The alkenyl group and the cycloalkenyl group optionally have a substituent and examples thereof include a vinyl group, a propenyl group, a butenyl group, a 3-butenyl group, a 3-pentenyl group, a 4-pentenyl group, a 1-hexenyl group, a 5-hexenyl group and a 7-octenyl group, and these groups having a substituent.

"The alkynyl group" may be any of linear and branched. The number of carbon atoms of the alkynyl group, not including carbon atoms of the substituent, is usually 2 to 20, and preferably 3 to 20. The number of carbon atoms of the branched alkynyl group, not including carbon atoms of the substituent, is usually 4 to 30, and preferably 4 to 20.

The number of carbon atoms of "the cycloalkynyl group", not including carbon atoms of the substituent, is usually 4 to 30, and preferably 4 to 20.

The alkynyl group and the cycloalkynyl group optionally have a substituent and examples thereof include an ethynyl group, a propynyl group, a butynyl group, a pentynyl group, a hexynyl group and a 5-hexynyl group, and these groups having a substituent.

"The crosslinkable group" is a group which is capable of generating a new bond by being substituted to heating, ultraviolet irradiation, near-ultraviolet irradiation, visible light irradiation, infrared irradiation, radical reaction and the like, and is preferably a group represented by any of the formula (B-1) to the formula (B-17). These groups optionally have a substituent.

[Chemical Formula 4]

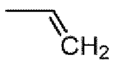
(B-1)
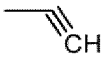
(B-2)
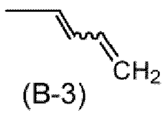
(B-3)
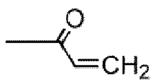
(B-4)
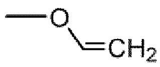
(B-5)
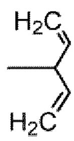
(B-6)
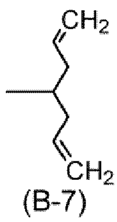
(B-7)
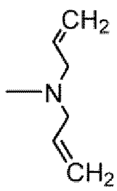
(B-8)

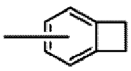
(B-9)
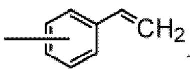
(B-10)
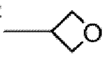
(B-11)
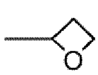
(B-12)
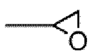
(B-13)
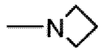
(B-14)
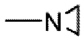
(B-15)
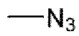
(B-16)
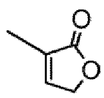
(B-17)

"The substituent" includes, for example, a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group and a cycloalkynyl group. The substituent may be a crosslinkable group. When a plurality of substituents are present, they may be combined together to form a ring together with atoms to which they are attached, but it is preferable that they do not form a ring.

"The amount of silicon atoms" can be measured by ICP emission spectrometry (inductively coupled plasma mass spectrometry). That is, "the amount of silicon atoms" means the mass concentration of silicon atoms when measured by ICP emission spectrometry. Further, when "the amount of silicon atoms" is "0 ppm by mass", it means that the mass concentration of silicon atoms when measured by ICP emission spectrometry is below the detection limit.

In the composition for light emitting device of the present embodiment, the host material means a material that physically, chemically or electrically interacts with a guest material. By this interaction, for example, the light emitting property, the charge transporting property or the charge injection property of the composition for light emitting device of the present embodiment can be improved or adjusted.

In the composition for light emitting device of the present embodiment, when the light emitting material is explained as an example, the guest material can be made to emit light more efficiently by electrically interacting with the host material and efficiently transferring electrical energy from the host material to the guest material.

<Host material>

The host material contains an aromatic compound having a condensed ring skeleton in which only three or more benzene rings are condensed. The aromatic compound having a condensed ring skeleton in which only three or more benzene rings are condensed may contain only one type of the condensed ring skeleton in which only three or more benzene rings are condensed or may contain two or more types thereof, in the compound. Further, the aromatic compound having a condensed ring skeleton in which only three or more benzene rings are condensed may contain only one condensed ring skeleton in which only three or more benzene rings are condensed or may contain two or more condensed ring skeletons, in the compound. Hereinafter, the aromatic compound having a condensed ring skeleton in which only three or more benzene rings are condensed contained in the host material is referred to as "aromatic compound for host material" in some cases.

In the condensed ring skeleton which the aromatic compound for host material has, the number of the condensed benzene rings is usually 3 to 10, and it is preferably 3 to 7, more preferably 3 to 5 and further preferably 3 or 4, since the initial deterioration of the light emitting device of the present embodiment is more suppressed.

The condensed ring skeleton which the aromatic compound for host material has can also be said to be a carbon skeleton of a condensed ring in which only three or more benzene rings are condensed. The condensed ring skeleton is preferably an anthracene skeleton, a phenanthrene skeleton, a benzoanthracene skeleton, a benzophenanthrene skeleton or a pyrene skeleton, more preferably an anthracene skeleton, a benzoanthracene skeleton or a pyrene skeleton and further preferably an anthracene skeleton, since the initial deterioration of the light emitting device of the present embodiment is more suppressed.

The aromatic compound for host material may be an aromatic hydrocarbon having a condensed ring skeleton in which only three or more benzene rings are condensed (hereinafter, referred to also as "condensed ring-containing aromatic hydrocarbon"), and the aromatic hydrocarbon optionally has a substituent. The substituent which the condensed ring-containing aromatic hydrocarbon optionally has is preferably a halogen atom, an alkyl group, a cycloalkyl group, an alkoxy group, a cycloalkoxy group, an aryl group, a monovalent heterocyclic group or a substituted amino group, more preferably an alkyl group, a cycloalkyl group, an aryl group or a monovalent heterocyclic group, further preferably an aryl group or a monovalent heterocyclic group and particularly preferably an aryl group, and these groups optionally further have a substituent.

The aryl group as the substituent which the condensed ring-containing aromatic hydrocarbon optionally has is preferably a group obtained by removing from a monocyclic or bicyclic to hexacyclic aromatic hydrocarbon one or more hydrogen atoms bonding directly to carbon atoms constituting the ring, more preferably a group obtained by removing from a monocyclic or bicyclic to tetracyclic aromatic hydrocarbon one or more hydrogen atoms bonding directly to carbon atoms constituting the ring, further preferably a group obtained by removing from benzene, naphthalene, dihydrophenanthrene, fluorene or benzofluorene one or more hydrogen atoms bonding directly to carbon atoms constituting the ring and particularly preferably a phenyl group or a naphthyl group, and these groups optionally have a substituent.

The monovalent heterocyclic group as the substituent which the condensed ring-containing aromatic hydrocarbon optionally has is preferably a group obtained by removing from a monocyclic or bicyclic to hexacyclic heterocyclic compound one or more hydrogen atoms bonding directly to atoms constituting the ring, more preferably a group obtained by removing from a monocyclic or bicyclic to tetracyclic heterocyclic compound one or more hydrogen atoms bonding directly to atoms constituting the ring, and more preferably a group obtained by removing from pyridine, diazabenzene, triazine, azanaphthalene, diazanaphthalene, dibenzofuran, dibenzothiophene, carbazole, benzocarbazole, benzonaphthofuran or benzonaphthothiophene one or more hydrogen atoms bonding directly to atoms constituting the ring, and these groups optionally have a substituent.

In the substituted amino group as the substituent which the condensed ring-containing aromatic hydrocarbon optionally has, the substituent which an amino group has is preferably an aryl group or a monovalent heterocyclic group, more preferably an aryl group, and these groups optionally further have a substituent. The examples and the preferable range of the aryl group as the substituent which an amino group has are the same as the examples and the preferable range of the aryl group as the substituent which the condensed ring-containing aromatic hydrocarbon optionally has. The examples and the preferable range of the monovalent heterocyclic group as the substituent which an amino group has are the same as the examples and the preferable range of the monovalent heterocyclic group as the substituent which the condensed ring-containing aromatic hydrocarbon optionally has.

It is preferable that the condensed ring-containing aromatic hydrocarbon has a substituent, since the initial deterioration of the light emitting device of the present embodiment is more suppressed. When the condensed ring-containing aromatic hydrocarbon has a substituent, the total number of the substituents which the condensed ring-containing aromatic hydrocarbon has is usually 1 to 20 (provided that, it is not higher than the total number of hydrogen atoms which the condensed ring-containing aromatic hydrocarbon has, the same shall apply hereinafter), and it is preferably 1 to 15, more preferably 1 to 10, further preferably 1 to 7, particularly preferably 1 to 5 and especially preferably 1 to 3, since synthesis of the host material is easy.

The substituent which the substituent which the condensed ring-containing aromatic hydrocarbon optionally has optionally further has is preferably a halogen atom, an alkyl group, a cycloalkyl group, an alkoxy group, a cycloalkoxy group, an aryl group, a monovalent heterocyclic group or a substituted amino group, more preferably an alkyl group, a cycloalkyl group, an aryl group, a monovalent heterocyclic group or a substituted amino group and further preferably an alkyl group or a cycloalkyl group, and these groups optionally further have a substituent, but it is preferable that they do not further have a substituent.

The examples and the preferable range of the aryl group, the monovalent heterocyclic group and the substituted amino group as the substituent which the substituent which the condensed ring-containing aromatic hydrocarbon optionally has optionally further has are the same as the examples and the preferable range of the aryl group, the monovalent heterocyclic group and the substituted amino group as the substituent which the condensed ring-containing aromatic hydrocarbon optionally has, respectively.

The host material may further contain the compound other than the aromatic compound for host material, however, it is preferable that the aromatic compound for host material is contained as the main component. The content ratio of the aromatic compound for host material occupying the host material may be, for example, 10% by mass or more, and it is preferably 30% by mass or more, more preferably 50% by mass or more, further preferably 70% by mass or more, particularly preferably 90% by mass or more and especially preferably 95% by mass or more and may also be 100% by mass, since the initial deterioration of the light emitting device of the present embodiment is more suppressed.

The host material may contain only one type of the aromatic compound for host material or may contain two or more types thereof. When the host material further contains a compound other than the aromatic compound for host material, the host material may contain only one type of the compound other than the aromatic compound for host material or may contain two or more types thereof.

In general, an aromatic compound for host material may be a polymer compound (hereinafter, referred to also as "polymer host material") or a low-molecular compound (hereinafter, referred to also as "low-molecular host material"), with the low-molecular host material being preferred. In the presently claimed invention, the host material specifically contains at least an aromatic compound for host material that is a compound represented by the formula (FH).

(Low-molecular host material)

The molecular weight of the low-molecular host material is usually $1\times10^2$ to $1\times10^4$, preferably $2\times10^2$ to $5\times10^3$, more preferably $3\times10^2$ to $2\times10^3$ and further preferably $4\times10^2$ to $1\times10^3$.

The total number of the condensed ring skeletons in which only three or more benzene rings are condensed contained in the low-molecular host material is usually 1 to 10, and it is preferably 1 to 7, more preferably 1 to 5, further preferably 1 to 3 and particularly preferably 1, since the initial deterioration of the light emitting device of the present embodiment is more suppressed.

The low-molecular host material may contain only one type of the condensed ring skeleton in which only three or more benzene rings are condensed or may contain two or more types thereof, and the number of the types is preferably 1 to 5, more preferably 1 to 3 and further preferably 1, since synthesis of the low-molecular host material is easy.

Since the initial deterioration of the light emitting device of the present embodiment is more suppressed, it is preferable that the low-molecular host material contains a condensed ring skeleton in which only three or more benzene rings are condensed, as a group obtained by removing from an aromatic hydrocarbon having a condensed ring skeleton in which only three or more benzene rings are condensed one or more hydrogen atoms bonding directly to carbon atoms constituting the condensed ring skeleton (hereinafter, referred to also as "condensed ring-containing aromatic hydrocarbon group"), and this group optionally has a substituent.

The total number of the condensed ring-containing aromatic hydrocarbon groups contained in the low-molecular host material is usually 1 to 10, and it is preferably 1 to 7, more preferably 1 to 5, further preferably 1 to 3 and particularly preferably 1, since the initial deterioration of the light emitting device of the present embodiment is more suppressed.

The low-molecular host material may contain only one type of the condensed ring-containing aromatic hydrocarbon group or may contain two or more types thereof, and the number of the types is preferably 1 to 5, more preferably 1 to 3 and further preferably 1, since synthesis of the low-molecular host material is easy.

In the low-molecular host material, the examples and the preferable range of the substituent which the condensed ring-containing aromatic hydrocarbon group optionally has are the same as the examples and the preferable range of the substituent which the condensed ring-containing aromatic hydrocarbon optionally has.

[Compound represented by the formula (FH)]

In the presently claimed invention, the host material contains at least a low-molecular host material that is a compound represented by the formula (FH), since the initial deterioration of the light emitting device of the present embodiment is more suppressed.

$n^{1H}$ is usually an integer of 10 or less, and it is preferably an integer of 7 or less, more preferably an integer of 5 or less and further preferably an integer of 3 or less, since synthesis of a compound represented by the formula (FH) is easy. Further, $n^{1H}$ is preferably an integer of 1 or more, since the initial deterioration of the light emitting device of the present embodiment is more suppressed.

The substituent which the condensed ring-containing aromatic hydrocarbon group represented by $Ar^{1H}$ optionally has is a substituent other than an aryl group and a monovalent heterocyclic group, and it is preferably a halogen atom, an alkyl group, a cycloalkyl group, an alkoxy group, a cycloalkoxy group or a substituted amino group and more preferably an alkyl group or a cycloalkyl group, and these groups optionally further have a substituent.

The examples and the preferable range of the substituted amino group as the substituent which the condensed ring-containing aromatic hydrocarbon group optionally has are the same as the examples and the preferable range of the substituted amino group as the substituent which the condensed ring-containing aromatic hydrocarbon optionally has.

The examples and the preferable range of the substituent which the substituent which the condensed ring-containing aromatic hydrocarbon group optionally has optionally further has are the same as the examples and the preferable range of the substituent which the substituent which the condensed ring-containing aromatic hydrocarbon optionally has optionally further has.

$R^{1H}$ is preferably an aryl group optionally having a substituent, since the initial deterioration of the light emitting device of the present embodiment is more suppressed.

The examples and the preferable range of the aryl group and the monovalent heterocyclic group represented by $R^{1H}$ are the same as the examples and the preferable range of the aryl group and the monovalent heterocyclic group as the substituent which the condensed ring-containing aromatic hydrocarbon optionally has, respectively.

The examples and the preferable range of the substituent which $R^{1H}$ optionally has are the same as the examples and the preferable range of the substituent which the substituent which the condensed ring-containing aromatic hydrocarbon optionally has optionally further has.

As the low-molecular host material, compounds represented by the following formulae and compounds described in examples are exemplified. These compounds optionally have a substituent. In the formulae, $Z^1$ represents an oxygen atom or a sulfur atom. When a plurality of $Z^1$ are present, they may be the same or different.

[Chemical Formula 5]

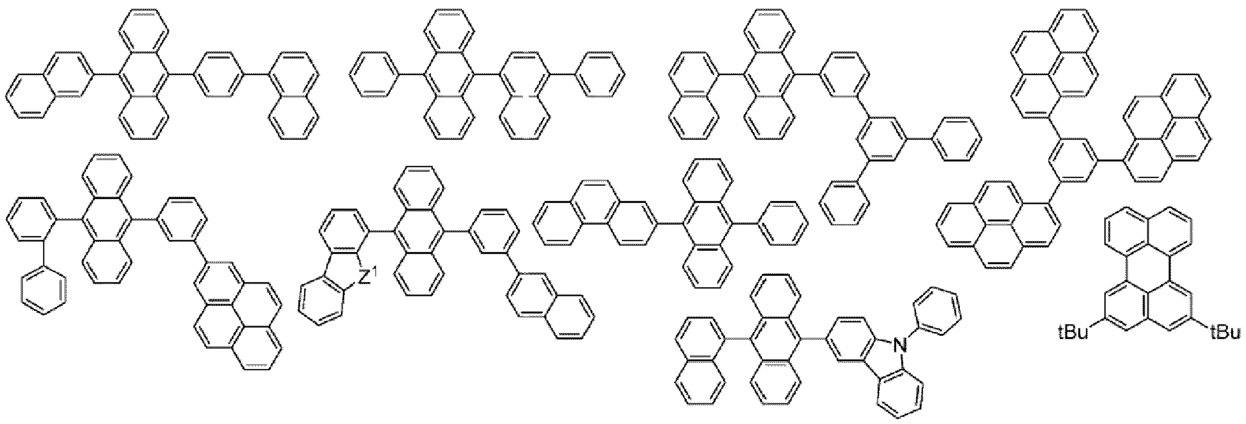

[Chemical Formula 6]

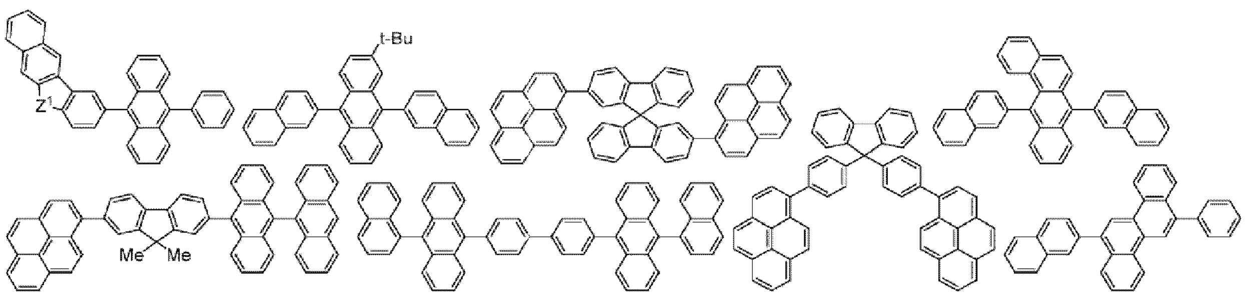

(Polymer host material)

The polystyrene-equivalent number-average molecular weight of the polymer host material is preferably $5\times10^3$ to $1\times10^6$, more preferably $1\times10^4$ to $5\times10^5$ and further preferably $2\times10^4$ to $2\times10^5$. The polystyrene-equivalent weight-average molecular weight of the polymer host material is preferably $1\times10^4$ to $2\times10^6$, more preferably $2\times10^4$ to $1\times10^6$ and further preferably $5\times10^4$ to $5\times10^5$.

The polymer host material may be any of a block copolymer, a random copolymer, an alternative copolymer and a graft copolymer, and may be in any other form, however, copolymers obtained by copolymerizing multiple types of raw material monomers are preferable.

It is preferable that the polymer host material contains a condensed ring skeleton in which only three or more benzene rings are condensed, as an aromatic hydrocarbon group having a condensed ring skeleton in which only three or more benzene rings are condensed, and this group optionally has a substituent.

Since the initial deterioration of the light emitting device of the present embodiment is more suppressed, the polymer host material preferably contains a condensed ring-containing aromatic hydrocarbon group and more preferably contains a group obtained by removing from a condensed ring-containing aromatic hydrocarbon two hydrogen atoms bonding directly to carbon atoms constituting the ring (divalent condensed ring-containing aromatic hydrocarbon group), in the main chain of the polymer compound. These groups optionally have a substituent.

In the polymer host material, the condensed ring-containing aromatic hydrocarbon group is preferably a group obtained by removing from a compound represented by the formula (FH) one or more (preferably 5 or less, more preferably 1 to 3 and further preferably 2) hydrogen atoms, since the initial deterioration of the light emitting device of the present embodiment is more suppressed.

In the polymer host material, the content of the condensed ring-containing aromatic hydrocarbon group contained in the polymer compound is usually 0.1% by mol to 100% by mol with respect to the total content of all constitutional units contained in the polymer compound, and it is preferably 1% by mol to 100% by mol, more preferably 10% by mol to 100% by mol and further preferably 30% by mol to 100% by mol, since the initial deterioration of the light emitting device of the present embodiment is more suppressed.

The polymer host material may contain only one type of the condensed ring-containing aromatic hydrocarbon group or may contain two or more types thereof, and the number of the types is preferably 1 to 5, more preferably 1 to 3 and further preferably 1, since synthesis of the polymer host material is easy.

In the polymer host material, the examples and the preferable range of the substituent which the condensed ring-containing aromatic hydrocarbon group optionally has are the same as the examples and the preferable range of the substituent which the condensed ring-containing aromatic hydrocarbon optionally has.

The polymer host material may contain a constitutional unit other than the condensed ring-containing aromatic hydrocarbon group in the polymer compound and preferably contains a constitutional unit other than the condensed ring-containing aromatic hydrocarbon group in the main chain of the polymer compound.

The constitutional unit other than the condensed ring-containing aromatic hydrocarbon group includes, for example, groups obtained by removing from an aromatic hydrocarbon group (preferably, an arylene group) other than the condensed ring-containing aromatic hydrocarbon group, a heterocyclic group (preferably, a divalent heterocyclic group) and an aromatic amine compound one or more hydrogen atoms (preferably, groups obtained by removing two hydrogen atoms), and these groups optionally have a substituent. The examples and the preferable range of this substituent are the same as the examples and the preferable range of the substituent which the condensed ring-containing aromatic hydrocarbon optionally has.

In the polymer host material, the total content of groups obtained by removing from the condensed ring-containing aromatic hydrocarbon group, an aromatic hydrocarbon group other than the condensed ring-containing aromatic hydrocarbon group, a heterocyclic group and an aromatic amine contained in the polymer compound one or more hydrogen atoms is usually 1% by mol to 100% by mol with respect to the total content of all constitutional units contained in the polymer compound, and it is preferably 50% by mol to 100% by mol and more preferably 70% by mol to 100% by mol, since the initial deterioration of the light emitting device of the present embodiment is more suppressed.

The polymer host material may contain only one type of the constitutional unit other than the condensed ring-containing aromatic hydrocarbon group or may contain two or more types thereof in the polymer compound.

<Guest material>

In general, the guest material includes a compound having a heterocyclic group containing a carbon atom and at least one selected from the group consisting of a boron atom, a nitrogen atom, a phosphorus atom, an oxygen atom, a sulfur atom and a selenium atom in the ring (hereinafter, referred to also simply as "heterocyclic group G").

The compound having a heterocyclic group G may contain only one type of the heterocyclic group G or may contain two or more types thereof, in the compound. Further, the compound having a heterocyclic group G may contain

only one heterocyclic group G or may contain two or more heterocyclic groups G, in the compound.

The number of carbon atoms of the heterocyclic group G, not including the number of carbon atoms of the substituent, is usually 1 to 60, preferably 2 to 40 and more preferably 3 to 25. The number of hetero atoms of the heterocyclic group G, not including the number of carbon atoms of the substituent, is usually 1 to 30, preferably 1 to 10, more preferably 1 to 5 and further preferably 1 to 3. The total number of a boron atom, a nitrogen atom, a phosphorus atom, an oxygen atom, a sulfur atom and a selenium atom in the heterocyclic group G, not including the number of carbon atoms of the substituent, is usually 1 to 30, preferably 1 to 10, more preferably 1 to 5 and further preferably 1 to 3.

The heterocyclic group G is preferably a heterocyclic group containing a carbon atom and at least one selected from the group consisting of a nitrogen atom, an oxygen atom and a sulfur atom in the ring, more preferably a heterocyclic group containing a carbon atom, and a nitrogen atom or an oxygen atom in the ring and further preferably a heterocyclic group containing a carbon atom and a nitrogen atom in the ring, since the initial deterioration of the light emitting device of the present embodiment is more suppressed. These groups optionally have a substituent.

The heterocyclic group G includes, for example, groups obtained by removing from a heterocyclic compound containing a carbon atom and at least one selected from the group consisting of a boron atom, a nitrogen atom, a phosphorus atom, an oxygen atom, a sulfur atom and a selenium atom in the ring among heterocyclic compounds exemplified in the section of the heterocyclic group described above one or more hydrogen atoms bonding directly to atoms constituting the ring. Of them, the heterocyclic group G is preferably a group obtained by removing from a monocyclic or bicyclic to heptacyclic heterocyclic compound one or more hydrogen atoms bonding directly to atoms constituting the ring, more preferably a group obtained by removing from a monocyclic or bicyclic to pentacyclic heterocyclic compound one or more hydrogen atoms bonding directly to atoms constituting the ring, further preferably a group obtained by removing from pyridine, diazabenzene, triazine, dibenzofuran, dibenzothiophene, carbazole, phenoxazine, phenothiazine, benzocarbazole, dibenzocarbazole, indolocarbazole or indenocarbazole one or more hydrogen atoms bonding directly to atoms constituting the ring, particularly preferably a group obtained by removing from pyridine, diazabenzene, triazine, carbazole, dibenzofuran, dibenzothiophene, benzocarbazole, dibenzocarbazole, indolocarbazole or indenocarbazole one or more hydrogen atoms bonding directly to atoms constituting the ring and especially preferably a group obtained by removing from pyridine, diazabenzene, triazine, carbazole, benzocarbazole, dibenzocarbazole, indolocarbazole or indenocarbazole one or more hydrogen atoms bonding directly to atoms constituting the ring, and these groups optionally have a substituent, since the initial deterioration of the light emitting device of the present embodiment is more suppressed.

The substituent which the heterocyclic group G optionally has is preferably a halogen atom, an alkyl group, a cycloalkyl group, an alkoxy group, a cycloalkoxy group, an aryloxy group, an aryl group, a monovalent heterocyclic group or a substituted amino group, more preferably an alkyl group, a cycloalkyl group, an aryl group, a monovalent heterocyclic group or a substituted amino group, further preferably an alkyl group, an aryl group or a monovalent heterocyclic group and particularly preferably an aryl group or a monovalent heterocyclic group, and these groups optionally have a substituent.

The examples and the preferable range of the aryl group, the monovalent heterocyclic group and the substituted amino group as the substituent which the heterocyclic group G optionally has are the same as the examples and the preferable range of the aryl group, the monovalent heterocyclic group and the substituted amino group as the substituent which the condensed ring-containing aromatic hydrocarbon optionally has, respectively.

The examples and the preferable range of the substituent which the substituent which the heterocyclic group G optionally has optionally further has are the same as the examples and the preferable range of the substituent which the substituent which the condensed ring-containing aromatic hydrocarbon optionally has optionally further has.

The guest material may further contain a compound other than the compound having a heterocyclic group G, but it is preferable that the compound having a heterocyclic group G is contained as the main component. The content ratio of the compound having a heterocyclic group G occupying the guest material may be, for example, 10% by mass or more, and it is preferably 30% by mass or more, more preferably 50% by mass or more, further preferably 70% by mass or more, particularly preferably 90% by mass or more and especially preferably 95% by mass or more and may also be 100% by mass, since the initial deterioration of the light emitting device of the present embodiment is more suppressed.

The guest material may contain only one type of the compound having a heterocyclic group G or may contain two or more types thereof. In the presently claimed invention, the guest material specifically contains at least an aromatic amine compound that is a compound represented by the formula (FB). When the guest material further contains a compound other than the compound having a heterocyclic group G, the guest material may contain only one type of the compound other than the compound having a heterocyclic group G or may contain two or more types thereof.

In general, the guest material may be a polymer compound (hereinafter, referred to also as "polymer guest material") or a low-molecular compound (hereinafter, referred to also as "low-molecular guest material"), with the low-molecular guest material being preferred.

(Low-molecular guest material)

The molecular weight of the low-molecular guest material is usually $1\times10^2$ to $1\times10^4$, preferably $2\times10^2$ to $5\times10^3$, more preferably $3\times10^2$ to $2\times10^3$ and further preferably $4\times10^2$ to $1\times10^3$.

The total number of the heterocyclic groups G contained in the low-molecular guest material is usually 1 to 20, and it is preferably 1 to 15, more preferably 1 to 10, further preferably 1 to 5 and particularly preferably 1 to 3, since the initial deterioration of the light emitting device of the present embodiment is more suppressed.

The low-molecular guest material may contain only one type of the heterocyclic group G or may contain two or more types thereof, and the number of types is preferably 1 to 10, more preferably 1 to 7, further preferably 1 to 5 and particularly preferably 1 to 3, since the initial deterioration of the light emitting device of the present embodiment is more suppressed.

[Compound represented by the formula (FB)]

In the presently claimed invention, the guest material contains at least a low-molecular guest material that is a compound represented by the formula (FB), since the initial deterioration of the light emitting device of the present embodiment is more suppressed.

$n^{1B}$ is usually an integer of 15 or less, and it is preferably an integer of 10 or less, more preferably an integer of 7 or less, further preferably an integer of 5 or less and particularly preferably an integer of 3 or less, since synthesis of a compound represented by the formula (FB) is easy. In contrast, $n^{1B}$ is preferably an integer of 1 or more, since the initial deterioration of the light emitting device of the present embodiment is more suppressed.

The examples and the preferable range of the group obtained by removing from a compound having a heterocyclic ring containing a carbon atom and at least one selected from the group consisting of a boron atom, a nitrogen atom, a phosphorus atom, an oxygen atom, a sulfur atom and a selenium atom in the ring $n^{1B}$ or more hydrogen atoms bonding directly to atoms constituting the heterocyclic ring represented by $Ar^{1B}$ are the same as the examples and the preferable range of the heterocyclic group G in the compound having a heterocyclic group G.

The substituent which $Ar^{1B}$ optionally has includes, for example, a cyano group, an alkenyl group, a cycloalkenyl group, an alkynyl group and a cycloalkynyl group, and these groups optionally further have a substituent.

The examples and the preferable range of the substituent which the substituent which $Ar^{1B}$ optionally has optionally further has are the same as the examples and the preferable range of the substituent which the substituent which the condensed ring-containing aromatic hydrocarbon optionally has optionally further has.

$R^{1B}$ is preferably an alkyl group, a cycloalkyl group, an aryl group, a monovalent heterocyclic group or a substituted amino group, more preferably an alkyl group, an aryl group or a monovalent heterocyclic group, and further preferably an aryl group or a monovalent heterocyclic group, and these groups optionally have a substituent, since the initial deterioration of the light emitting device of the present embodiment is more suppressed.

The examples and the preferable range of the aryl group, the monovalent heterocyclic group and the substituted amino group represented by $R^{1B}$ are the same as the examples and the preferable range of the aryl group, the monovalent heterocyclic group and the substituted amino group as the substituent which the condensed ring-containing aromatic hydrocarbon optionally has, respectively.

The examples and the preferable range of the substituent which $R^{1B}$ optionally has are the same as the examples and the preferable range of the substituent which the substituent which the condensed ring-containing aromatic hydrocarbon optionally has optionally further has.

As the low-molecular guest material, compounds represented by the following formulae and compounds described in examples are exemplified. These compounds optionally have a substituent. In the formulae, $Z^1$ represents the same meaning as described above. $Z^2$ represents a group represented by -N= or a group represented by -CH=.

[Chemical Formula 7]

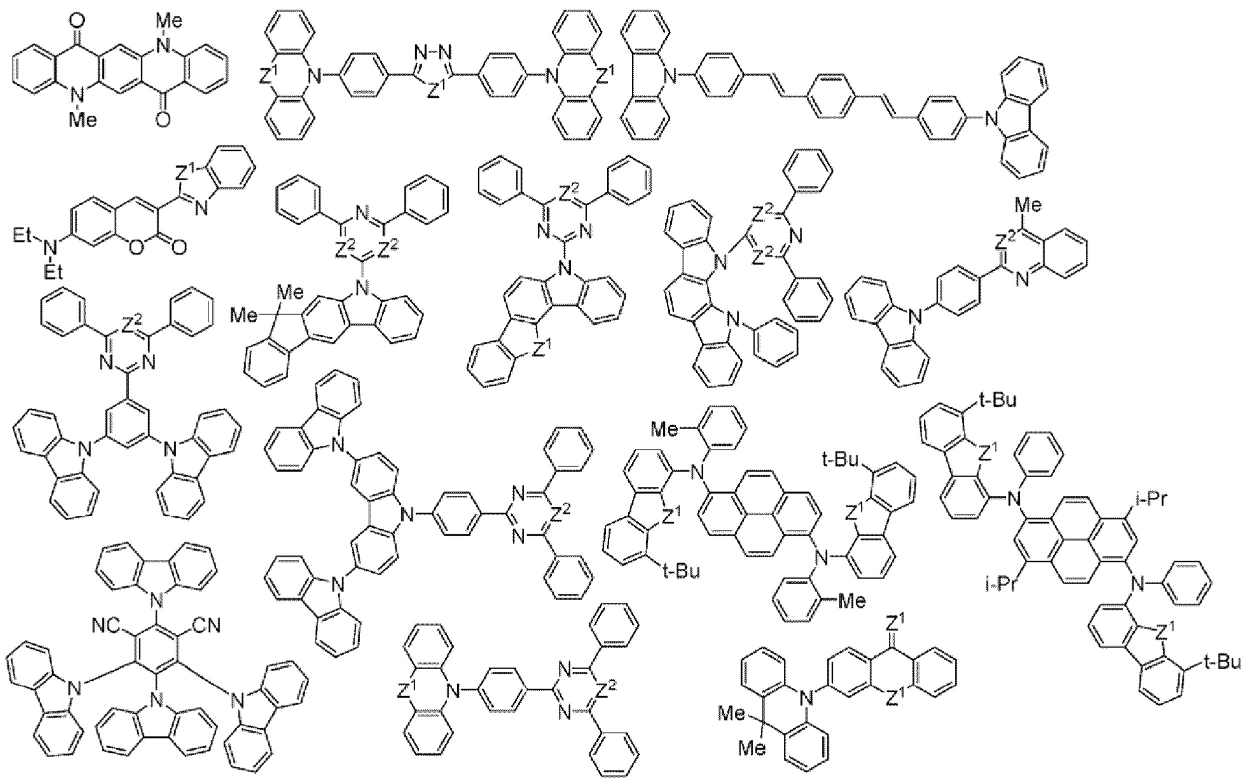

(Polymer guest material)

The preferable ranges of the polystyrene-equivalent number-average molecular weight and weight-average molecular weight of the polymer guest material are the same as the preferable ranges of the polystyrene-equivalent number-average molecular weight and weight-average molecular weight of the polymer host material, respectively.

The polymer guest material may be any of a block copolymer, a random copolymer, an alternative copolymer and a graft copolymer, and may also be in any other form, and copolymers obtained by copolymerizing multiple types of raw material monomers are preferable.

The polymer guest material contains a heterocyclic group G in the polymer compound. The polymer guest material preferably contains a heterocyclic group G in the main chain of the polymer compound, since the initial deterioration of the light emitting device of the present embodiment is more suppressed.

In the polymer guest material, the heterocyclic group G is preferably a group obtained by removing from a compound represented by the formula (FB) one or more (preferably 5 or less, more preferably 1 to 3 and further preferably 2) hydrogen atoms, since the initial deterioration of the light emitting device of the present embodiment is more suppressed.

In the polymer guest material, the content of the heterocyclic group G is usually 0.1% by mol to 100% by mol with respect to the total content of all constitutional units contained in the polymer compound, and it is preferably 1% by mol to 100% by mol, more preferably 5% by mol to 100% by mol and further preferably 10% by mol to 100% by mol, since the initial deterioration of the light emitting device of the present embodiment is more suppressed.

The polymer guest material may contain only one type of the heterocyclic group G or may contain two or more types thereof, and the number of types is preferably 1 to 10, more preferably 1 to 7, further preferably 1 to 5 and particularly preferably 1 to 3, since the initial deterioration of the light emitting device of the present embodiment is more suppressed.

The polymer guest material may contain a constitutional unit other than the heterocyclic group G, and preferably contains a constitutional unit other than the heterocyclic group G in the main chain of the polymer compound.

The constitutional unit other than the heterocyclic group G includes, for example, groups obtained by removing from an aromatic hydrocarbon group (preferably, an arylene group), a heterocyclic group other than the heterocyclic group G (preferably, a divalent heterocyclic group) and an aromatic amine one or more hydrogen atoms (preferably, groups obtained by removing two hydrogen atoms), and these groups optionally have a substituent. The examples and the preferable range of this substituent are the same as the examples and the preferable range of the substituent which the condensed ring-containing aromatic hydrocarbon optionally has.

In the polymer guest material, the total content of groups obtained by removing from the heterocyclic group **G,** an aromatic hydrocarbon group, a heterocyclic group other than the heterocyclic group G and an aromatic amine contained in

the polymer compound one or more hydrogen atoms is usually 1% by mol to 100% by mol with respect to the total content of all constitutional units contained in the polymer compound, and it is preferably 50% by mol to 100% by mol and more preferably 70% by mol to 100% by mol, since the initial deterioration of the light emitting device of the present embodiment is more suppressed.

The polymer guest material may contain only one type of the constitutional unit other than the heterocyclic group G or may contain two or more types thereof in the polymer compound.

<Amount ($C^H$) of silicon atoms contained in host material>

In the composition for light emitting device of the present embodiment, the amount ($C^H$) of silicon atoms contained in the host material is usually 0 ppm by mass or more and 2300 ppm by mass or less with respect to the total amount of the host material. The phrase "the amount of silicon atoms contained in the host material" is not intended that the host material contains silicon atoms, and the host material may or may not contain silicon atoms. In the host material of the present embodiment, the amount of silicon atoms is preferably 1000 ppm by mass or less, more preferably 500 ppm by mass or less, further preferably 230 ppm by mass or less, particularly preferably 100 ppm by mass or less, especially preferably 50 ppm by mass or less, especially more preferably 24 ppm by mass or less, especially further preferably 23 ppm by mass or less and especially particularly preferably 20 ppm by mass or less, since the initial deterioration of the light emitting device of the present embodiment is more suppressed. In contrast, in the host material of the present embodiment, the amount of silicon atoms is preferably 0.001 ppm by mass or more, more preferably 0.005 ppm by mass or more, further preferably 0.01 ppm by mass or more, particularly preferably 0.05 ppm by mass or more, especially preferably 0.1 ppm by mass or more, especially more preferably 0.2 ppm by mass or more, especially further preferably 0.4 ppm by mass or more and especially particularly preferably 0.5 ppm by mass or more, since the initial deterioration of the light emitting device of the present embodiment is more suppressed.

Regarding the amount ($C^H$) of silicon atoms contained in the host material of the present embodiment, when one type of the host material of the present embodiment is present, the amount of silicon atoms in that one type of the host material is $C^H$, and when the host material of the present embodiment is constituted of multiple types of compounds having different amounts of silicon atoms, $C^H$ is calculated according to the amounts of silicon atoms in the multiple types of compounds and the mass ratio of each compound. The specific method for calculating $C^H$ is explained using Example D1 and Example D2 described later.

First, in Example D1, since the amount of silicon atoms in a compound H2 measured by an ICP emission spectrometry method is below the detection limit, $C^H$ is 0 ppm by mass.

Next, in Example D2, the amount of silicon atoms in a compound H1 and a compound H2 measured by an ICP emission spectrometry method are 24 ppm by mass and below the detection limit (namely, 0 ppm by mass), respectively. The mass ratio of the compound H1 to the compound H2 is compound H1:compound H2 = 2:88.

Hence, $C^H$ in Example D2 can be determined from the amounts of silicon atoms contained in the compound H1 and the compound H2 and the charge amounts thereof, and calculated as described below.

$$C^H = \{72\times2/(2+88)\}+\{0\times88/(2+88)\} = 0.53 \text{ ppm by mass}$$

Similarly, $C^H$ in Comparative Example CD1 is 24 ppm by mass.

<Amount ($C^1$) of silicon atoms contained in guest material>

In the composition for light emitting device of the present embodiment, the amount ($C^1$) of silicon atoms contained in the guest material is usually 0 ppm by mass or more and 8000 ppm by mass or less with respect to the total amount of the guest material. The phrase "the amount of silicon atoms contained in the guest material" is not intended that the guest material contains silicon atoms, and the guest material may or may not contain silicon atoms. In the guest material of the present embodiment, the amount of silicon atoms is preferably 5000 ppm by mass or less, more preferably 1000 ppm by mass or less, further preferably 800 ppm by mass or less, particularly preferably 500 ppm by mass or less, especially preferably 100 ppm by mass or less and especially more preferably 80 ppm by mass or less. In contrast, in the guest material of the present embodiment, the amount of silicon atoms is preferably 0.001 ppm by mass or more, more preferably 0.01 ppm by mass or more, further preferably 0.1 ppm by mass or more, particularly preferably 1 ppm by mass or more, especially preferably 10 ppm by mass or more, especially more preferably 30 ppm by mass or more and especially further preferably 60 ppm by mass or more.

For example, in Example D1, $C^1$ is 72 ppm by mass. In Example D2, $C^H$ is 72 ppm by mass. In Comparative Example CD1, $C^1$ is 72 ppm by mass.

<$C^1$ and $C^H$ reduction method>

The method of reducing $C^1$ and $C^H$ includes, for example, purification.

The purification includes known purification methods described in 4th Edition Experimental Chemistry Course (1993, Maruzen), 5th Edition Experimental Chemistry Course (2007, Maruzen), New Experimental Chemistry Course (1975, Maruzen), Guide to Organic Chemical Experiment (1988, Kagaku-Dojin Publishing Company, Inc.), and the like.

The purification includes, for example, sublimation, extraction, reprecipitation, recrystallization, chromatography and adsorption.

The purification method for the low-molecular guest material and the low-molecular host material is preferably sublimation, recrystallization, chromatography or adsorption and more preferably sublimation or recrystallization, since the mount of silicon atoms can be reduced.

The purification method for the polymer guest material and the polymer host material is preferably reprecipitation, chromatography or adsorption, since the mount of silicon atoms can be reduced.

When the purification is performed twice or more, the methods may be the same or different.

In sublimation, the degree of vacuum and the sublimation temperature may be appropriately set according to the material to be sublimated. The degree of vacuum is preferably $1\times10^{-10}$ Pa to $1\times10^{5}$ Pa, more preferably $1\times10^{-7}$ Pa to $1\times10^{2}$ Pa, further preferably $1\times10^{-5}$ Pa to 1 Pa and particularly preferably $1\times10^{-4}$ Pa to $1\times10^{-2}$ Pa. The sublimation temperature is preferably -100°C to 1000°C, more preferably 0°C to 700°C, further preferably 100°C to 500°C and particularly preferably 200°C to 350°C.

The extraction is preferably liquid separation, or solid-liquid extraction with a Soxhlet extractor.

The solvent used for extraction includes, for example, alcohol solvents such as methanol, ethanol, propanol, ethylene glycol, glycerin, 2-methoxyethanol, 2-ethoxyethanol and the like; ether solvents such as diethyl ether, tetrahydrofuran (THF), dioxane, cyclopentyl methyl ether, diglyme and the like; halogen-based solvents such as methylene chloride, chloroform and the like; nitrile solvents such as acetonitrile, benzonitrile and the like; hydrocarbon solvents such as hexane, decalin, toluene, xylene, mesitylene and the like; amide solvents such as N,N-dimethylformamide, N,N-dimethylacetamide and the like; acetone, dimethyl sulfoxide, and water. The solvent may be used singly or in combination of two or more.

The chromatography is preferably column chromatography.

As the filler used for column chromatography, silica gel or alumina is preferable.

The examples of the solvent used for chromatography are the same as the examples of the solvent used for extraction.

The examples of the solvent used for reprecipitation and recrystallization are the same as the examples of the solvent used for extraction.

As the adsorption, a treatment with an adsorbent is preferred. The adsorbent is preferably activated carbon, silica gel, alumina or Celite.

The treatment with an adsorbent is usually performed in a solvent. The examples of the solvent used for the treatment with an adsorbent are the same as the examples of the solvent used for extraction.

<Composition for light emitting device>

The composition for light emitting device of the present embodiment contains a host material and a guest material.

The composition for light emitting device of the present embodiment may contain only one type or two or more types of each of the host material and the guest material.

In the composition for light emitting device of the present embodiment, the maximum peak wavelength of the emission spectrum of the host material at room temperature is preferably shorter than the maximum peak wavelength of the emission spectrum of the guest material at room temperature.

In the composition for light emitting device of the present embodiment, the maximum peak wavelength of the emission spectrum of the host material at room temperature is preferably 300 nm or more and 500 nm or less, more preferably 330 nm or more and 480 nm or less and further preferably 360 nm or more and 460 nm or less.

In the composition for light emitting device of the present embodiment, the maximum peak wavelength of the emission spectrum of the guest material at room temperature is preferably 380 nm or more and 590 nm or less, more preferably 420 nm or more and 570 nm or less, further preferably 440 nm or more and 550 nm or less and particularly preferably 480 nm or more and 530 nm or less.

The maximum peak wavelength of the emission spectrum of the host material and the guest material can be evaluated by dissolving the measurement object in an organic solvent such as xylene, toluene, chloroform, tetrahydrofuran and the like to prepare a dilute solution ($1\times10^{-6}$% by mass to $1\times10^{-3}$% by mass) and measuring the PL spectrum of the dilute solution at room temperature. As the organic solvent for dissolving the measurement object, toluene or xylene

is preferable.

In the composition for light emitting device of the present embodiment, the total amount of silicon atoms contained in the host material and silicon atoms contained in the guest material is 7 ppm by mass or more and 28 ppm by mass or less with respect to the total amount of the host material and the guest material. In the composition for light emitting device of the present embodiment, the total amount of silicon atoms contained in the host material and silicon atoms contained in the guest material with respect to the total amount of the host material and the guest material is 28 ppm by mass or less, more preferably 27 ppm by mass or less, further preferably 26 ppm by mass or less and particularly preferably 25 ppm by mass or less, since the initial deterioration of the light emitting device of the present embodiment is more suppressed. In contrast, in the composition for light emitting device of the present embodiment, the total amount of silicon atoms contained in the host material and silicon atoms contained in the guest material with respect to the total amount of the host material and the guest material is 7 ppm by mass or more and preferably 7.5 ppm by mass or more, since the initial deterioration of the light emitting device of the present embodiment is more suppressed.

In the present embodiment, the reason why the initial deterioration of the light emitting device is suppressed is considered as follows.

The aromatic compound for host material contained as the host material in the composition for light emitting device of the present embodiment has a condensed ring skeleton in which only three or more benzene rings are condensed. The present inventors consider that such a condensed ring skeleton electrically interacts with the heterocyclic group G in the compound having a heterocyclic group G contained in the guest compound. In contrast, the present inventors consider that the heterocyclic group G in the compound having a heterocyclic group G contained as the guest material in the composition for light emitting device of the present embodiment electrically interacts with the aromatic compound for host material contained as the host material.

Further, the present inventors consider that when the total amount of silicon atoms contained in the host material and silicon atoms contained in the guest material exceeds a predetermined upper limit amount in the composition for light emitting device of the present embodiment, silicon atoms exert an adverse effect on the interaction described above, and resultantly cause a lowering of the light emitting property, the charge transporting property or the charge injection property of the composition for light emitting device of the present embodiment or render the charge balance of the light emitting device of the present embodiment to be disturbed, leading to promotion of the initial deterioration of the light emitting device of the present embodiment.

In contrast, the present inventors consider that when the total amount of silicon atoms contained in the host material and silicon atoms contained in the guest material is below a predetermined lower limit amount in the composition for light emitting device of the present embodiment, silicon atoms reinforce the interaction described above, and resultantly improve the light emitting property, the charge transporting property or the charge injection property of the composition for light emitting device of the present embodiment or improve the charge balance of the light emitting device of the present embodiment, leading to suppression of the initial deterioration of the light emitting device of the present embodiment.

Thus, the present inventors consider based on the above idea that when the total amount of silicon atoms contained in the host material and silicon atoms contained in the guest material is a predetermined amount in the present embodiment, the effect of suppression of the initial deterioration of the light emitting device is obtained.

For example, when solid contents blended in the composition for light emitting device of the present embodiment are composed only of a host material and a guest material, the total amount of silicon atoms contained in the host material and silicon atoms contained in the guest material (ppm by mass) is represented by $C^HW^H+C^1W^1$, when the ratio of the mass of the host material to the total mass of the host material and the guest material is represented by $W^H$ and the ratio of the mass of the guest material to the total mass of the host material and the guest material is represented by $W^1$.

The total amount of silicon atoms contained in the host material and silicon atoms contained in the guest material (ppm by mass) is represented by $C^HW^H+C^1W^1$, when the ratio of the mass of the host material to the total mass of the host material and the guest material is represented by $W^H$ and the ratio of the mass of the guest material to the total mass of the host material and the guest material is represented by $W^1$.

$W^H$ is usually 0.01 to 0.9999, and it is preferably 0.30 to 0.999, more preferably 0.50 to 0.995, further preferably 0.70 to 0.99 and particularly preferably 0.85 to 0.95, since the initial deterioration of the light emitting device of the present embodiment is more suppressed.

$W^1$ is usually 0.0001 to 0.99, and it is preferably 0.001 to 0.70, more preferably 0.005 to 0.50, further preferably 0.01 to 0.30 and particularly preferably 0.05 to 0.15, since the initial deterioration of the light emitting device of the present embodiment is more suppressed.

The specific method for calculating $W^H$ and $W^1$ is explained using Example D1 and Example D2 described later.

First, in Example D1, the mass ratio of a compound H2 (host material) to a compound EM2 (guest material) is compound H2:compound EM2 = 90:10.

Hence, $W^H$ and $W^1$ in Example D1 can be determined from the charge amounts, and calculated as follows.

$$W^H = 90/(90+10) = 0.90$$

$$W^1 = 10/(90+10) = 0.10$$

In Example D2, the mass ratio of a compound H2, a compound H1 and a compound EM1 is compound H2:compound H1:compound EM1 = 88:2:10.

Hence, $W^H$ and $W^1$ in Example D2 can be determined from the charge amounts, and calculated as follows.

$$W^H = (88+2)/(88+2+10) = 0.90$$

$$W^1 = 10/(88+2+10) = 0.10$$

Similarly, $W^H$ and $W^1$ in Comparative Example CD1 are calculated as described below.

$$W^H = 90/(90+10) = 0.90$$

$$W^1 = 10/(90+10) = 0.10$$

As described above, $C^HW^H+C^1W^1$ can be calculated by calculating $C^1$, $C^H$, $W^1$ and $W^H$.

For example, $C^HW^H+C^1W^1$ in Example D1 is calculated as described below.

$$C^HW^H+C^1W^1 = (0\times0.90)+(72\times0.10) = 7.2 \text{ ppm by mass}$$

For example, $C^HW^H+C^1W^1$ in Example D2 is calculated as described below.

$$C^HW^H+C^1W^1 = (0.53\times0.90)+(72\times0.10) = 7.7 \text{ ppm by mass}$$

For example, $C^HW^H+C^1W^1$ in Comparative Example CD1 is calculated as described below.

$$C^HW^H+C^1W^1 = (24\times0.90)+(72\times0.10) = 29 \text{ ppm by mass}$$

$C^HW^H+C^1W^1$ is 7 ppm by mass or more and 28 ppm by mass or less. $C^HW^H+C^1W^1$ is 28 ppm by mass or less, more preferably 27 ppm by mass or less, further preferably 26 ppm by mass or less and particularly preferably 25 ppm by mass or less, since the initial deterioration of the light emitting device of the present embodiment is more suppressed. In contrast, $C^HW^H+C^1W^1$ is 7 ppm by mass or more and preferably 7.5 ppm by mass or more, since the initial deterioration of the light emitting device of the present embodiment is more suppressed.

(Other components)

The composition for light emitting device of the present embodiment may be a composition containing a host material, a guest material, and at least one material selected from the group consisting of a hole transporting material, a hole injection material, an electron transporting material, an electron injection material, a light emitting material, an antioxidant and a solvent. However, the hole transporting material, the hole injection material, the electron transporting material, the electron injection material and the light emitting material are different from the host material and the guest material.

When the composition for light emitting device of the present embodiment further contains at least one material selected from the group consisting of a hole transporting material, a hole injection material, an electron transporting material, an electron injection material, a light emitting material, an antioxidant and a solvent, it is preferable that the amount of silicon atoms contained in them is reduced beforehand by the above-described purification.

[Ink]

A composition containing a host material, a guest material and a solvent (hereinafter, referred to as "ink") is suitable for fabrication of a light emitting device using a wet method such as, for example, a spin coat method, a casting method, a microgravure coat method, a gravure coat method, a bar coat method, a roll coat method, a wire bar coat

method, a dip coat method, a spray coat method, a screen printing method, a flexo printing method, an offset printing method, an inkjet printing method, a capillary coat method, a nozzle coat method and the like. The viscosity of the ink may be adjusted according to the type of the printing method, and it is preferably 1 mPa•s to 20 mPa•s at 25°C.

The solvent contained in the ink is preferably a solvent capable of dissolving or uniformly dispersing the solid content in the ink. The solvent includes, for example, chlorine-based solvents, ether solvents, aromatic hydrocarbon solvents, aliphatic hydrocarbon solvents, ketone solvents, ester solvents, polyhydric alcohol solvents, alcohol solvents, sulfoxide solvents and amide solvents.

In the ink, the blending amount of the solvent is usually 1000 parts by mass to 100000 parts by mass, when the sum of the host material and the guest material is taken as 100 parts by mass.

The solvent may be used singly or in combination of two or more.

[Hole transporting material]

The hole transporting material is classified into a low-molecular compound and a polymer compound, and is preferably a polymer compound having a crosslinkable group.

The polymer compound includes, for example, polyvinylcarbazole and derivatives thereof; and polyarylenes having an aromatic amine structure in the side chain or main chain, and derivatives thereof. The polymer compound may be a compound to which an electron accepting portion such as fullerene, tetrafluorotetracyanoquinodimethane, tetracyanoethylene and trinitrofluorene and the like is bonded.

In the composition for light emitting device of the present embodiment, when a hole transporting material is contained, the blending amount of the hole transporting material is usually 1 part by mass to 400 parts by mass, when the sum of the host material and the guest material is taken as 100 parts by mass.

The hole transporting material may be used singly or in combination of two or more.

[Electron transporting material]

The electron transporting material is classified into a low-molecular compound and a polymer compound. The electron transporting material may have a crosslinkable group.

The low-molecular compound includes, for example, a metal complex having 8-hydroxyquinoline as a ligand; oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.

The polymer compound includes, for example, polyphenylene, polyfluorene, and derivatives thereof. The polymer compound may be doped with a metal.

In the composition for light emitting device of the present embodiment, when an electron transporting material is contained, the blending amount of the electron transporting material is usually 1 part by mass to 400 parts by mass, when the sum of the host material and the guest material is taken as 100 parts by mass.

The electron transporting material may be used singly or in combination of two or more.

[Hole injection material and electron injection material]

The hole injection material and the electron injection material are each classified into a low-molecular compound and a polymer compound. The hole injection material and the electron injection material may have a crosslinkable group.

The low-molecular compound includes, for example, metal phthalocyanines such as copper phthalocyanine and the like; carbon; oxides of metals such as molybdenum, tungsten and the like; and metal fluorides such as lithium fluoride, sodium fluoride, cesium fluoride, potassium fluoride and the like.

The polymer compound includes, for example, conductive polymers such as polyaniline, polythiophene, polypyrrole, polyphenylenevinylene, polythienylenevinylene, polyquinoline and polyquinoxaline, and derivatives thereof; and polymers containing an aromatic amine structure in the main chain or side chain, and the like.

In the composition for light emitting device pf the present embodiment, when a hole injection material and/or an electron injection material is contained, the blending amount of each of the hole injection material and the electron injection material is usually 1 part by mass to 400 parts by mass, when the sum of the host material and the guest material is taken as 100 parts by mass.

The hole injection material and the electron injection material each may be used singly or in combination of two or more.

[Ion doping]

When the hole injection material or the electron injection material contains a conductive polymer, the electrical

conductivity of the conductive polymer is preferably $1 \times 10^{-5}$ S/cm to $1 \times 10^{3}$ S/cm. In order to set the electric conductivity of the conductive polymer within the above range, the conductive polymer can be doped with an appropriate amount of ions. The types of ions to be doped are anions for hole injection materials and cations for electron injection materials. The anion includes, for example, a polystyrenesulfonate ion, an alkylbenzenesulfonate ion and a camphorsulfonate ion. The cation includes, for example, a lithium ion, a sodium ion, a potassium ion and a tetrabutylammonium ion.

The ions to be doped may be used singly or in combination of two or more.

[Light emitting material]

The light emitting material is classified into a low-molecular compound and a polymer compound. The light emitting material may have a crosslinkable group.

The low-molecular compound includes, for example, naphthalene and derivatives thereof, anthracene and derivatives thereof, perylene and derivatives thereof, and triplet light emitting complexes having iridium, platinum or europium as a central metal.

The polymer compound includes, for example, arylene groups such as a phenylene group, a naphthalenediyl group, a fluorenediyl group, a phenanthrenediyl group, a dihydrophenanthrenediyl group, an anthracenediyl group and a pyrenediyl group and the like; aromatic amine residues such as a group obtained by removing from an aromatic amine two hydrogen atoms, and the like; and polymer compounds containing a divalent heterocyclic group such as a carbazolediyl group, a phenoxazinediyl group and a phenothiazinediyl group and the like.

In the composition for light emitting device of the present embodiment, when a light emitting material is contained, the content of the light emitting material is usually 0.1 parts by mass to 400 parts by mass, when the sum of the host material and the guest material is taken as 100 parts by mass.

The light emitting material may be used singly or in combination of two or more.

[Antioxidant]

The antioxidant may be a compound that is soluble in the same solvent as for the host material and the guest material and does not inhibit light emission and charge transportation, and includes, for example, a phenol-based antioxidant and a phosphorus-based antioxidant.

In the composition for light emitting device of the present embodiment, when an antioxidant is contained, the blending amount of the antioxidant is usually 0.001 parts by mass to 10 parts by mass, when the sum of the host material and the guest material is taken as 100 parts by mass.

The antioxidant may be used singly or in combination of two or more.

<Film>

The film contains the composition for light emitting device of the present embodiment, and is suitable as a light emitting layer in the light emitting device. The film can be fabricated, for example, by a wet method using an ink. Further, the film can be fabricated, for example, by a dry method such as a vacuum vapor deposition method and the like. The method for fabricating the film by a dry method includes, for example, a method of vapor-depositing the composition for light emitting device of the present embodiment, and a method of co-vapor-depositing the host material and the guest material.

The thickness of the film is usually 1 nm to 10 $\mu$m.

<Light emitting device>

The light emitting device of the present embodiment contains the composition for light emitting device described above.

The constitution of the light emitting device of the present embodiment has, for example, an anode, a cathode, and an organic layer containing the composition for light emitting device of the present embodiment disposed between the above-described anode and the above-described cathode.

[Film constitution]

The layer containing the composition for light emitting device of the present embodiment is usually one or more selected from the group consisting of a light emitting layer, a hole transporting layer, a hole injection layer, an electron transporting layer and an electron injection layer, and preferable is a light emitting layer. These layers contain a light emitting material, a hole transporting material, a hole injection material, an electron transporting material and an electron injection material, respectively. These layers can be formed from a light emitting material, a hole transporting material, a

hole injection material, an electron transporting material and an electron injection material, respectively, using the same method as that for film fabrication described above.

The light emitting device has a light emitting layer between an anode and a cathode. The light emitting device of the present embodiment preferably has at least one of a hole injection layer and a hole transporting layer between an anode and a light emitting layer from the standpoint of hole injectability and hole transportability, and preferably has at least one of an electron injection layer and an electron transporting layer between a cathode and a light emitting layer from the standpoint of electron injectability and electron transportability.

The materials of the hole transporting layer, the electron transporting layer, the light emitting layer, the hole injection layer and the electron injection layer include the hole transporting material, the electron transporting material, the light emitting material, the hole injection material and the electron injection material described above, respectively, in addition to the composition for light emitting device of the present embodiment.

When the material of the hole transporting layer, the material of the electron transporting layer and the material of the light emitting layer are soluble in a solvent used in forming a layer adjacent to the hole transporting layer, the electron transporting layer and the light emitting layer, respectively, it is preferable that the material has a crosslinkable group for preventing the material from being dissolved in the solvent. After forming each layer using the material having a crosslinkable group, the layer can be insolubilized by crosslinking the crosslinkable group.

The method of forming each of the light emitting layer, the hole transporting layer, the electron transporting layer, the hole injection layer, the electron injection layer and the like in the light emitting device of the present embodiment includes, for example, dry methods such as a method of vacuum vapor deposition from a powder and the like and wet methods such as a method by film formation from a solution or melted state and the like when a low molecular compound is used, and includes, for example, wet methods such as a method by film formation from a solution or melted state and the like when a polymer compound is used. The order, the number and the thickness of the layers to be laminated are adjusted in consideration of, for example, the light emission efficiency and the initial deterioration.

[Substrate/electrode]

The substrate in the light emitting device may be a substrate on which an electrode can be formed and which does not chemically change when forming an organic layer, and is a substrate made of a material such as, for example, glass, plastic, silicon and the like. In the case of an opaque substrate, it is preferable that the electrode farthest from the substrate is transparent or semitransparent.

The material of the anode includes, for example, conductive metal oxides and semitransparent metals, preferably, indium oxide, zinc oxide, tin oxide; conductive compounds such as indium•tin•oxide (ITO), indium•zinc•oxide, and the like; a composite of argentine, palladium and copper (APC); NESA, gold, platinum, silver, and copper.

The material of the cathode includes, for example, metals such as lithium, sodium, potassium, rubidium, cesium, beryllium, magnesium, calcium, strontium, barium, aluminum, zinc, indium and the like; alloys composed of two or more of them; alloys composed of one or more of them and one or more of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

The anode and the cathode each may take a laminated structure composed of two or more layers.

The light emitting device of the present embodiment can be suitably used as a light source for backlight of liquid crystal display devices, a light source for illumination devices, an organic EL lighting device, and, a display device of computers, televisions, mobile terminals and the like (for example, organic EL displays and organic EL televisions).

A suitable embodiment of the present invention is described above, but the present invention is not limited to the above-described embodiment.

For example, one aspect of the present invention may relate to a method for producing a composition for light emitting device containing a host material and a guest material blended therein.

<Production method (1)>

In one embodiment, the method for producing a composition for light emitting device may be a composition for light emitting device production method comprising a host material preparation step of preparing a host material containing an aromatic compound having a condensed ring skeleton in which only three or more benzene rings are condensed, a guest material preparation step of preparing a guest material containing a compound having a heterocyclic group containing a carbon atom and at least one selected from the group consisting of a boron atom, a nitrogen atom, a phosphorus atom, an oxygen atom, a sulfur atom and a selenium atom in the ring, and a production step of mixing the host material and the guest material at a blending ratio such that the total amount of silicon atoms contained in the host material and silicon atoms contained in the guest material is 7 ppm by mass or more and 28 ppm by mass or less to obtain a

composition for light emitting device (hereinafter, referred to also as "production method (1)").

In the production method (1), the host material preparation step may comprise a step (A-1) of preparing an aromatic compound having a condensed ring skeleton in which only three or more benzene rings are condensed containing silicon atoms mixed therein, and a step (A-2) of purifying at least a part of the aromatic compound having a condensed ring skeleton in which only three or more benzene rings are condensed prepared in the step (A-1) to remove at least a part of the silicon atoms.

In the production method (1), the content of silicon atoms in the aromatic compound having a condensed ring skeleton in which only three or more benzene rings are condensed prepared in the step (A-1) is not particularly restricted and, for example, may be 24 ppm by mass or more, may be 25 ppm by mass or more, may be 50 ppm by mass or more, may be 100 ppm by mass or more, may be 500 ppm by mass or more, may be 1000 ppm by mass or more, may be 5000 ppm by mass or more and may also be 10000 ppm by mass or more. The upper limit of the content of silicon atoms in the aromatic compound having a condensed ring skeleton in which only three or more benzene rings are condensed prepared in the step (A-1) is not particularly restricted, and the content, for example, may be 500000 ppm by mass or less, may be 100000 ppm by mass or less and may also be 50000 ppm by mass or less.

As the purification method of the step (A-2) in the production method (1), methods exemplified in <$C^1$ and $C^H$ reduction method> described above are mentioned.

The content of silicon atoms in the aromatic compound having a condensed ring skeleton in which only three or more benzene rings are condensed after the step (A-2) in the production method (1) is usually 0 ppm by mass or more and 2300 ppm by mass or less. The content of silicon atoms in the aromatic compound having a condensed ring skeleton in which only three or more benzene rings are condensed after the step (A-2) is preferably 1000 ppm by mass or less, more preferably 500 ppm by mass or less, further preferably 230 ppm by mass or less, particularly preferably 100 ppm by mass or less, especially preferably 50 ppm by mass or less, especially more preferably 24 ppm by mass or less, especially further preferably 23 ppm by mass or less and especially particularly preferably 20 ppm by mass or less, since the initial deterioration of the light emitting device of the present embodiment is more suppressed. In contrast, the content of silicon atoms in the aromatic compound having a condensed ring skeleton in which only three or more benzene rings are condensed after the step (A-2) is preferably 0.001 ppm by mass or more, more preferably 0.005 ppm by mass or more, further preferably 0.01 ppm by mass or more, particularly preferably 0.05 ppm by mass or more, especially preferably 0.1 ppm by mass or more, especially more preferably 0.2 ppm by mass or more, especially further preferably 0.4 ppm by mass or more and especially particularly preferably 0.5 ppm by mass or more, since the initial deterioration of the light emitting device of the present embodiment is more suppressed.

The guest material preparation step in the production method (1) may comprise a preparation step (B-1) of preparing a compound having a heterocyclic group containing a carbon atom and at least one selected from the group consisting of a boron atom, a nitrogen atom, a phosphorus atom, an oxygen atom, a sulfur atom and a selenium atom in the ring containing silicon atoms mixed therein, and a step (B-2) of purifying at least a part of the compound having a heterocyclic group containing a carbon atom and at least one selected from the group consisting of a boron atom, a nitrogen atom, a phosphorus atom, an oxygen atom, a sulfur atom and a selenium atom in the ring prepared in the step (B-1) to remove at least a part of the silicon atoms.

In the production method (1), the content of silicon atoms in the compound having a heterocyclic group containing a carbon atom and at least one selected from the group consisting of a boron atom, a nitrogen atom, a phosphorus atom, an oxygen atom, a sulfur atom and a selenium atom in the ring prepared in the step (B-1) is not particularly restricted, and for example, may be 72 ppm by mass or more, may be 73 ppm by mass or more, may be 80 ppm by mass or more, may be 100 ppm by mass or more, may be 500 ppm by mass or more, may be 1000 ppm by mass or more, may be 5000 ppm by mass or more and may also be 10000 ppm by mass or more. In contrast, the upper limit of the content of silicon atoms in the compound having a heterocyclic group containing a carbon atom and at least one selected from the group consisting of a boron atom, a nitrogen atom, a phosphorus atom, an oxygen atom, a sulfur atom and a selenium atom in the ring prepared in the step (B-1) is not particularly restricted, and the content, for example, may be 500000 ppm by mass or less, may be 100000 ppm by mass or less and may also be 50000 ppm by mass or less.

As the purification method of the step (B-2) in the production method (1), methods exemplified in <$C^1$ and $C^H$ reduction method> described above are mentioned.

The content of silicon atoms in the compound having a heterocyclic group containing a carbon atom and at least one selected from the group consisting of a boron atom, a nitrogen atom, a phosphorus atom, an oxygen atom, a sulfur atom and a selenium atom in the ring after the step (B-2) is usually 0 ppm by mass or more and 8000 ppm by mass or less. The content of silicon atoms in the compound having a heterocyclic group containing a carbon atom and at least one selected from the group consisting of a boron atom, a nitrogen atom, a phosphorus atom, an oxygen atom, a sulfur atom and a selenium atom in the ring after the step (B-2) is preferably 5000 ppm by mass or less, more preferably 1000 ppm by mass or less, further preferably 800 ppm by mass or less, particularly preferably 500 ppm by mass or less, especially preferably 100 ppm by mass or less and especially more preferably 80 ppm by mass or less. In contrast, the content of silicon atoms in the compound having a heterocyclic group containing a carbon atom and at least one selected from the

group consisting of a boron atom, a nitrogen atom, a phosphorus atom, an oxygen atom, a sulfur atom and a selenium atom in the ring after the step (B-2) is preferably 0.001 ppm by mass or more, more preferably 0.01 ppm by mass or more, further preferably 0.1 ppm by mass or more, particularly preferably 1 ppm by mass or more, especially preferably 10 ppm by mass or more, especially more preferably 30 ppm by mass or more and especially further preferably 60 ppm by mass or more.

In the production method (1), the host material and the guest material are mixed in the production step at a blending ratio such that the total amount of both is over 0 ppm by mass and 28 ppm by mass or less in consideration of the amount of silicon atoms contained in the host material and the amount of silicon atoms contained in the guest material. By this, it is possible to obtain a composition for light emitting device with which the initial deterioration of the light emitting device can be suppressed.

The method of mixing the host material and the guest material in the production step in the production method (1) is not particularly restricted and includes, for example, a method of dissolving the host material and the guest material in the solvent explained in the section of the ink described above and mixing them, a method of mixing the host material and the guest material at the solid state, a method of mixing the host material and the guest material by co-vapor-deposition, and the like.

The production method (1) may further comprise a host material measurement step of measuring the content of silicon atoms contained in the aromatic compound for host material. The production method (1) may further comprise a guest material measurement step of measuring the content of silicon atoms contained in the compound having a heterocyclic group containing a carbon atom and at least one selected from the group consisting of a boron atom, a nitrogen atom, a phosphorus atom, an oxygen atom, a sulfur atom and a selenium atom in the ring. It is preferable that the production method (1) comprises the host material measurement step and the guest material measurement step. The method for measuring the content of silicon atoms in the host material measurement step and the guest material measurement step is preferably an ICP emission spectrometry method.

It is preferable that the host material measurement step and the guest material measurement step are carried out before the production step in the production method (1).

In the production method (1), the host material preparation step preferably comprises the host material measurement step. In the production method (1), the guest material preparation step preferably comprises the guest material measurement step.

<Production method (2)>

In another embodiment, the method for producing a composition for light emitting device may be a composition for light emitting device production method comprising a host material preparation step of preparing a host material containing an aromatic compound having a condensed ring skeleton in which only three or more benzene rings are condensed, a determination step of determining the blending ratio of the guest material to the host material, a guest material preparation step of preparing a guest material

which contains a compound having a heterocyclic group containing a carbon atom and at least one selected from the group consisting of a boron atom, a nitrogen atom, a phosphorus atom, an oxygen atom, a sulfur atom and a selenium atom in the ring and with which, when mixed with the host material at the above-described blending ratio, the total amount of silicon atoms contained in the host material and silicon atoms contained in the guest material with respect to the total amount of the host material and the guest material is 7 ppm by mass or more and 28 ppm by mass or less, and a production step of mixing the host material and the guest material at the blending ratio to obtain a composition for light emitting device (hereinafter, referred to also as "production method (2)").

In the production method (2), the host material preparation step may comprise a step (A-1) of preparing an aromatic compound having a condensed ring skeleton in which only three or more benzene rings are condensed containing silicon atoms mixed therein, and a step (A-2) of purifying at least a part of the aromatic compound having a condensed ring skeleton in which only three or more benzene rings are condensed prepared in the step (A-1) to remove at least a part of the silicon atoms. The step (A-1) and the step (A-2) in the production method (2) may be the same as the step (A-1) and the step (A-2) in the production method (1) described above.

In the production method (2), the blending ratio may be determined according to the properties of a light emitting device in the determination step. In the determination step, for example, the blending ratio may be determined based on the fabrication results of a light emitting device with a test composition using materials similar to the host material and the guest material described above, or the blending ratio may be determined based on the fabrication results of a light emitting device with a test composition in which the content of silicon atoms exceeds 28 ppm by mass.

In the guest material preparation step in the production method (2), the content of silicon atoms allowable for the guest material is determined according to the content of silicon atoms in the host material prepared in the host material preparation step and the blending ratio determined in the determination step. That is, the guest material preparation step can be said to be a step of preparing a guest material in which the content of silicon atoms is within a permissible range.

In the production method (2), the guest material preparation step may comprise, for example, a preparation step

(B-1) of preparing a compound having a heterocyclic group containing a carbon atom and at least one selected from the group consisting of a boron atom, a nitrogen atom, a phosphorus atom, an oxygen atom, a sulfur atom and a selenium atom in the ring containing silicon atoms mixed therein, and a step (B-2) of purifying at least a part of the compound having a heterocyclic group containing a carbon atom and at least one selected from the group consisting of a boron atom, a nitrogen atom, a phosphorus atom, an oxygen atom, a sulfur atom and a selenium atom in the ring prepared in the step (B-1) to remove at least a part of the silicon atoms. The step (B-1) and the step (B-2) in the production method (2) may be the same as the step (B-1) and the step (B-2) in the production method (1) described above.

In the production step in the production method (2), the host material prepared in the host material preparation step and the guest material prepared in the guest material preparation step are mixed at the blending ratio determined in the determination step. By this, it is possible to obtain a composition for light emitting device with which the initial deterioration of the light emitting device can be suppressed.

The method for mixing the host material and the guest material in the production step in the production method (2) may be the same as the method for mixing the host material and the guest material in the production step in the production method (1).

The production method (2) may further comprise the host material measurement step described above. The production method (2) may further comprise the guest material measurement step described above. It is preferable that the production method (2) comprises the host material measurement step described above and the guest material measurement step described above.

In the production method (2), it is preferable that the host material measurement step described above and the guest material measurement step described above are carried out before the production step.

In the production method (2), the host material preparation step preferably comprises the host material measurement step described above. In the production method (2), the guest material preparation step preferably comprises the guest material measurement step described above.

<Production method (3)>

In still another embodiment, the method for producing a composition for light emitting device may be a composition for light emitting device production method comprising a guest material preparation step of preparing a guest material containing a compound having a heterocyclic group containing a carbon atom and at least one selected from the group consisting of a boron atom, a nitrogen atom, a phosphorus atom, an oxygen atom, a sulfur atom and a selenium atom in the ring, a determination step of determining the blending ratio of the host material to the guest material, a host material preparation step of preparing a host material which contains an aromatic compound having a condensed ring skeleton in which only three or more benzene rings are condensed and with which, when mixed with the guest material at the above-described blending ratio, the total amount of silicon atoms contained in the host material and silicon atoms contained in the guest material with respect to the total amount of host material and the guest material is 7 ppm by mass or more and 28 ppm by mass or less, and a production step of mixing the guest material and the host material at the above-described blending ratio to obtain a composition for light emitting device (hereinafter, referred to also as "production method (3)").

In the production method (3), the guest material preparation step may comprise a step (B-1) of preparing a compound having a heterocyclic group containing a carbon atom and at least one selected from the group consisting of a boron atom, a nitrogen atom, a phosphorus atom, an oxygen atom, a sulfur atom and a selenium atom in the ring containing silicon atoms mixed therein, and a step (B-2) of purifying at least a part of the compound having a heterocyclic group containing a carbon atom and at least one selected from the group consisting of a boron atom, a nitrogen atom, a phosphorus atom, an oxygen atom, a sulfur atom and a selenium atom in the ring prepared in the step (B-1) to remove at least a part of the silicon atoms. The step (B-1) and the step (B-2) in the production method (3) may be the same as the step (B-1) and the step (B-2) in the production method (1)

In the production method (3), the blending ratio may be determined according to the properties of a light emitting device in the determination step. In the determination step, for example, the blending ratio may be determined based on the fabrication results of a light emitting device with a test composition using materials similar to the host material and the guest material described above, or the blending ratio may be determined based on the fabrication results of a light emitting device with a test composition in which the content of silicon atoms exceeds 28 ppm by mass.

In the host material preparation step in the production method (3), the content of silicon atoms allowable for the host material is determined according to the content of silicon atoms in the guest material prepared in the guest material preparation step and the blending ratio determined in the determination step. That is, the host material preparation step can be said to be a step of preparing the host material in which the content of silicon atoms is within a permissible range.

In the production method (3), the host material preparation step may comprise, for example, a preparation step (A-1) of preparing an aromatic compound having a condensed ring skeleton in which only three or more benzene rings are condensed containing silicon atoms mixed therein, and a step (A-2) of purifying at least a part of the aromatic compound

having a condensed ring skeleton in which only three or more benzene rings are condensed prepared in the step (A-1) to remove at least a part of the silicon atoms. The step (A-1) and the step (A-2) in the production method (3) may be the same as the step (A-1) and the step (A-2) in the production method (1) described above.

In the production step in the production method (3), the guest material prepared in the guest material preparation step and the host material prepared in the host material preparation step are mixed at the blending ratio determined in the determination step. By this, it is possible to obtain a composition for light emitting device with which the initial deterioration of the light emitting device can be suppressed.

The method for mixing the host material and the guest material in the production step in the production method (3) may be the same as the method for mixing the host material and the guest material in the production step in the production method (1).

The production method (3) may further comprise the host material measurement step described above. The production method (3) may further comprise the guest material measurement step described above. It is preferable that the production method (3) comprises the host material measurement step described above and the guest material measurement step described above.

In the production method (3), it is preferable that the host material measurement step described above and the guest material measurement step described above are carried out before the production step.

In the production method (3), the host material preparation step preferably comprises the host material measurement step described above. In the production method (3), the guest material preparation step preferably comprises the guest material measurement step described above.

<Production method (4)>

In still another embodiment, the method for producing a composition for light emitting device may be a composition for light emitting device production method comprising a host material preparation step of preparing an aromatic compound having a condensed ring skeleton in which only three or more benzene rings are condensed as the host material, a guest material preparation step of preparing a compound having a heterocyclic group containing a carbon atom and at least one selected from the group consisting of a boron atom, a nitrogen atom, a phosphorus atom, an oxygen atom, a sulfur atom and a selenium atom in the ring as the guest material, a determination step of determining the blending ratio of the host material and the guest material, a purification step of purifying at least a part of the aromatic compound having a condensed ring skeleton in which only three or more benzene rings are condensed and the compound having a heterocyclic group containing a carbon atom and at least one selected from the group consisting of a boron atom, a nitrogen atom, a phosphorus atom, an oxygen atom, a sulfur atom and a selenium atom in the ring such that when mixing the host material and the guest material at the above-described blending ratio, the total amount of silicon atoms contained in the host material and silicon atoms contained in the guest material with respect to the total amount of the host material and the guest material is 7 ppm by mass or more and 28 ppm by mass or less, and a production step of mixing the host material containing the aromatic compound having a condensed ring skeleton in which only three or more benzene rings are condensed and the guest material containing the compound having a heterocyclic group containing a carbon atom and at least one selected from the group consisting of a boron atom, a nitrogen atom, a phosphorus atom, an oxygen atom, a sulfur atom and a selenium atom in the ring at the above-described blending ratio to obtain a composition for light emitting device (hereinafter, referred to also as "production method (4)").

In the production method (4), silicon atoms may be mixed in at least one of the aromatic compound having a condensed ring skeleton in which only three or more benzene rings are condensed prepared in the host material preparation step and the compound having a heterocyclic group containing a carbon atom and at least one selected from the group consisting of a boron atom, a nitrogen atom, a phosphorus atom, an oxygen atom, a sulfur atom and a selenium atom in the ring prepared in the guest material preparation step. That is, the host material preparation step may be a step of preparing an aromatic compound having a condensed ring skeleton in which only three or more benzene rings are condensed containing silicon atoms mixed therein, or the guest material preparation step may be a step of preparing a compound having a heterocyclic group containing a carbon atom and at least one selected from the group consisting of a boron atom, a nitrogen atom, a phosphorus atom, an oxygen atom, a sulfur atom and a selenium atom in the ring containing silicon atoms mixed therein.

In the production method (4), the blending ratio may be determined according to the properties of a light emitting device in the determination step. In the determination step, for example, the blending ratio may be determined based on the fabrication results of a light emitting device with a test composition using materials similar to the host material and the guest material described above, the blending ratio may be determined based on the fabrication results of a light emitting device with a test composition in which the content of silicon atoms exceeds 28 ppm by mass, or the blending ratio may be determined based on the fabrication results of a light emitting device with a test composition prepared by mixing with the aromatic compound having a condensed ring skeleton in which only three or more benzene rings are condensed and the compound having a heterocyclic group containing a carbon atom and at least one selected from the group consisting of a

boron atom, a nitrogen atom, a phosphorus atom, an oxygen atom, a sulfur atom and a selenium atom in the ring prepared in the host material preparation step and the guest material preparation step.

In the purification step in the production method (4), at least a part of the aromatic compound having a condensed ring skeleton in which only three or more benzene rings are condensed and the compound having a heterocyclic group containing a carbon atom and at least one selected from the group consisting of a boron atom, a nitrogen atom, a phosphorus atom, an oxygen atom, a sulfur atom and a selenium atom in the ring is purified. As the purification method, methods exemplified in <$C^1$ and $C^H$ reduction method> described above are mentioned. The purification step may be a step of purifying only one of the aromatic compound having a condensed ring skeleton in which only three or more benzene rings are condensed and the compound having a heterocyclic group containing a carbon atom and at least one selected from the group consisting of a boron atom, a nitrogen atom, a phosphorus atom, an oxygen atom, a sulfur atom and a selenium atom in the ring, or a step of purifying both the aromatic compound having a condensed ring skeleton in which only three or more benzene rings are condensed and the compound having a heterocyclic group containing a carbon atom and at least one selected from the group consisting of a boron atom, a nitrogen atom, a phosphorus atom, an oxygen atom, a sulfur atom and a selenium atom in the ring.

In the production step in the production method (4), the aromatic compound having a condensed ring skeleton in which only three or more benzene rings are condensed and the compound having a heterocyclic group containing a carbon atom and at least one selected from the group consisting of a boron atom, a nitrogen atom, a phosphorus atom, an oxygen atom, a sulfur atom and a selenium atom in the ring are mixed at the blending ratio determined in the determination step. In this procedure, the total amount of silicon atoms contained in the host material and silicon atoms contained in the guest material with respect to the total amount of the host material and the guest material is 7 ppm by mass or more and 28 ppm by mass or less, since the purification step is involved. By this, it is possible to obtain a composition for light emitting device with which the initial deterioration of a light emitting device can be suppressed.

The method for mixing the host material and the guest material in the production step in the production method (4) may be the same as the method for mixing the host material and the guest material in the production step in the production method (1).

The production method (4) may further comprise the host material measurement step described above. The production method (4) may further comprise the guest material measurement step described above. It is preferable that the production method (4) comprises the host material measurement step described above and the guest material measurement step described above.

In the production method (4), it is preferable that the host material measurement step described above and the guest material measurement step described above are carried out before the production step.

In the production method (4), it is preferable that the host material preparation step or the purification step comprises the host material measurement step described above. In the production method (4), it is preferable that the guest material preparation step or the purification step comprises the guest material measurement step described above.

Another aspect of the present invention relates to a method for producing a light emitting device. This production method may be a method for producing a light emitting device containing an anode, a cathode, and an organic layer disposed between the anode and the cathode, comprising a step of forming the above-described organic layer with the composition for light emitting device produced by any of the production methods (1) to (4) described above.

In the method for producing a light emitting device of the present embodiment, the organic layer can be formed, for example, by using the same method as for fabrication of a film described above.

Further, in the method for producing a light emitting device of the present embodiment, the production method described in the column of <Light emitting device> described above may be used.

Furthermore, as the light emitting device in the method for producing a light emitting device of the present embodiment, for example, light emitting devices described in the column of <Light emitting device> described above are mentioned.

## EXAMPLES

The present invention will be illustrated further in detain by examples below, but the present invention is not limited to these examples.

In the present examples, the maximum peak wavelength of the emission spectrum of a compound was measured by a spectrophotometer (manufactured by JASCO Corporation, FP-6500) at room temperature. A compound was dissolved in xylene at a concentration of about $0.8 \times 10^{-4}$% by mass and the resultant xylene solution was used as a sample. As the excitation light, UV light with a wavelength of 325 nm was used.

In the present examples, the amount of silicon atoms contained in a compound was measured by an ICP emission spectrometry method.

<Synthesis of compound H1>

A compound H1 was synthesized with reference to a method described in Japanese Unexamined Patent Application Publication (JP-A) No. 2011-105643.

[Chemical Formula 8]

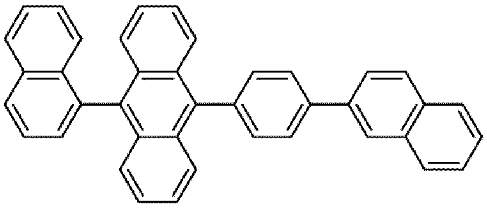

compound H1 and H2

The HPLC area percentage value of the compound H1 was 99.5% or more. The amount ($C^H$) of silicon atoms contained in the compound H1 was 24 ppm by mass.

<Purification of compound H1 (Synthesis of compound H2)>

Sublimation purification of the compound H1 was repeated until the amount of silicon atoms contained in the compound H1 became the detection limit or less (0 ppm by mass), to obtain a compound H2. In sublimation purification, the degree of vacuum was set to $3\times10^{-3}$ Pa to $5\times10^{-3}$ Pa, and the sublimation temperature was set to 250°C to 300°C.

The HPLC area percentage value of the compound H2 was 99.5% or more. The amount ($C^1$) of silicon atoms contained in the compound H2 was below the detection limit (0 ppm by mass).

<Synthesis and purification of compound EM1>

Recrystallization of a compound EM1 synthesized with reference to a method described in International Publication WO2008/056746 was repeated, to obtain a compound EM1. In the recrystallization, a mixed solvent of tetrahydrofuran and methanol and a mixed solvent of toluene and heptane were used.

The HPLC area percentage value of the compound EM1 was 99.5% or more. The amount of silicon atoms ($C^1$) contained in the compound EM1 was 72 ppm by mass.

[Chemical Formula 9]

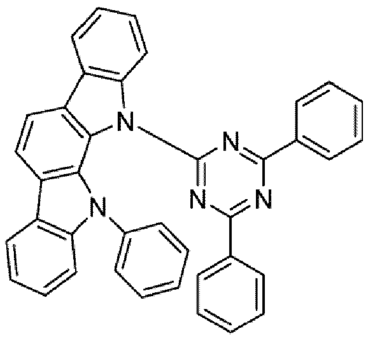

compound EM1

The maximum peak wavelength of the emission spectrum of the compounds H1 and H2 was 421 nm.

The maximum peak wavelength of the emission spectrum of the compound EM1 was 510 nm.

<Example D1> Fabrication and evaluation of light emitting device D1

(Formation of anode and hole injection layer)

An ITO film was attached with a thickness of 45 nm to a glass substrate by a sputtering method, for form an anode.

On the anode, a hole injection material ND-3202 (manufactured by Nissan Chemical Corporation) was spin-coated to form a film with a thickness of 35 nm. The substrate carrying the hole injection layer laminated thereon was placed under an air atmosphere and heated on a hot plate at 50°C for 3 minutes, and further, heated at 230°C for 15 minutes, to form a hole injection layer.

(Formation of hole transporting layer)

A polymer compound HTL-1 was dissolved in xylene at a concentration of 0.7% by mass. The resultant xylene solution was spin-coated on the hole injection layer, to form a film with a thickness of 20 nm which was then placed under a nitrogen gas atmosphere and heated on a hot plate at 180°C for 60 minutes, to form a hole transporting layer. The polymer compound HTL-1 is a polymer compound of Polymer Example 1 in International Publication WO2014/102543.

(Formation of light emitting layer)

The compound H2 and the compound EM1 (compound H2/compound EM1 = 90% by mass/10% by mass) were dissolved at a concentration of 2% by mass in toluene. The resultant toluene solution was spin-coated on the hole transporting layer, to form a film with a thickness of 60 nm which was then placed under a nitrogen gas atmosphere and heated at 130°C for 10 minutes, to form a light emitting layer.

(Formation of cathode)

The substrate carrying the light emitting layer formed thereon was placed in a vapor deposition machine and the internal pressure was reduced to $1.0\times10^{-4}$ Pa or less, then, sodium fluoride was vapor-deposited with a thickness of about 4 nm on the light emitting layer, then, aluminum was vapor-deposited with a thickness of about 80 nm on the sodium fluoride layer, as cathodes. After vapor deposition, sealing was performed with a glass substrate, to fabricate a light emitting device D1.

(Evaluation of light emitting device)

Voltage was applied to the light emitting device D1, to observe EL emission. The current value was set so that the initial luminance was 500 cd/$m^2$, then, the device was driven at constant current, and the time until the luminance reached 97% of the initial luminance (hereinafter, referred to also as "LT97") was measured.

<Examples D2 to D6 and Comparative Example CD1>

Fabrication and evaluation of light emitting devices D2 to D6 and CD1

Light emitting devices D2 to D6 and CD1 were fabricated in the same manner as in Example D1, except that materials described in Table 1 were used at the material ratios described in Table 1 instead of "the compound H2 and the compound EM1 (compound H2/compound EM1 = 90% by mass/10% by mass)" in (Formation of light emitting layer) of Example D1.

Voltage was applied to the light emitting devices D2 to D6 and CD1, to observe EL emission. LT97 of the light emitting devices D2 to D6 and CD1 was measured.

The results of Examples D1 to D6 and Comparative Example CD1 are shown in Table 1. The relative values of LT97 of the light emitting devices D1 to D6 if LT97 of the light emitting device CD1 is taken as 1.0 are shown.

[Table 1]

| | light emitting device | Light emitting layer | | | | | LT97 (relative value) |
|---|---|---|---|---|---|---|---|
| | | Material | Material ratio (% by mass) | $C^H$ (ppm by mass) | $C^1$ (ppm by mass) | $C^HW^H+C^1W^1$ (ppm by mass) | |
| Example D1 | D1 | H2/EM1 | 90/10 | 0 | 72 | 7.2 | 2.5 |
| Example D2 | D2 | H2/H1/EM1 | 88/2/10 | 0.53 | 72 | 7.7 | 10.7 |
| Example D3 | D3 | H2/H1/EM1 | 85.5/4.5/10 | 1.2 | 72 | 8.3 | 10.6 |
| Example D4 | D4 | H2/H1/EM1 | 81/9/10 | 2.4 | 72 | 9.4 | 7.8 |

(continued)

| | light emitting device | Light emitting layer | | | | | LT97 (relative value) |
|---|---|---|---|---|---|---|---|
| | | Material | Material ratio (% by mass) | $C^H$ (ppm by mass) | $C^1$ (ppm by mass) | $C^HW^H+C^1W^1$ (ppm by mass) | |
| Example D5 | D5 | H2/H1/EM1 | 45/45/10 | 12 | 72 | 18 | 13.0 |
| Example D6 | D6 | H2/H1/EM1 | 18/72/10 | 19 | 72 | 24 | 8.7 |
| Comparative Example CD1 | CD1 | H1/EM1 | 90/10 | 24 | 72 | 29 | 1.0 |

Industrial Applicability

According to the present invention, a composition which is useful for production of a light emitting device of which initial deterioration is suppressed is provided. The present invention is industrially useful since production of a light emitting device of which initial deterioration is suppressed has effects such as resource saving, energy saving and the like.

## Claims

**1.** A composition for light emitting device containing a host material and a guest material blended therein, wherein

said host material contains an aromatic compound having a condensed ring skeleton in which only three or more benzene rings are condensed,
said guest material contains a compound having a heterocyclic group containing a carbon atom and at least one selected from the group consisting of a boron atom, a nitrogen atom, a phosphorus atom, an oxygen atom, a sulfur atom and a selenium atom in the ring, and
the total amount of silicon atoms contained in said host material and silicon atoms contained in said guest material is 7 ppm by mass or more and 28 ppm by mass or less with respect to the total amount of said host material and said guest material, and wherein:

(a) said aromatic compound having a condensed ring skeleton in which only three or more benzene rings are condensed is a compound represented by the formula (FH) :

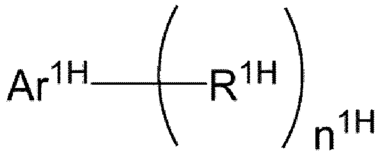

(FH)

wherein,

$n^{1H}$ represents an integer of 0 or more,
$Ar^{1H}$ represents a group obtained by removing from an aromatic hydrocarbon having a condensed ring skeleton in which only three or more benzene rings are condensed $n^{1H}$ or more hydrogen atoms bonding directly to carbon atoms constituting said condensed ring skeleton, and this group optionally has a substituent, when a plurality of the substituents are present, they may be the same or different and may be combined together to form a ring together with atoms to which they are attached,
$R^{1H}$ represents an aryl group or a monovalent heterocyclic group, and these groups optionally have a substituent, when a plurality of the substituents are present, they may be the same or different and may be combined together to form a ring together with atoms to which they are attached, when a plurality of $R^{1H}$ are present, they may be the same or different and may be combined together to form a ring together with atoms to which they are attached; and

(b) said compound having the heterocyclic group is a compound represented by the formula (FB):

$$Ar^{1B}-\left(R^{1B}\right)_{n^{1B}} \quad \text{(FB)}$$

wherein,

$n^{1B}$ represents an integer of 0 or more.
$Ar^{1B}$ represents a group obtained by removing from a compound having a heterocyclic ring containing a carbon atom and at least one selected from the group consisting of a boron atom, a nitrogen atom, a phosphorus atom, an oxygen atom, a sulfur atom and a selenium atom in the ring $n^{1B}$ or more hydrogen atoms bonding directly to atoms constituting the above-described heterocyclic ring, and this group optionally has a substituent, when a plurality of the substituents are present, they may be the same or different and may be combined together to form a ring together with atoms to which they are attached.
$R^{1B}$ represents a halogen atom, an alkyl group, a cycloalkyl group, an alkoxy group, a cycloalkoxy group, an aryloxy group, an aryl group, a monovalent heterocyclic group or a substituted amino group, and these groups optionally have a substituent, when a plurality of the substituents are present, they may be the same or different and may be combined together to form a ring together with atoms to which they are attached, when a plurality of $R^{1B}$ are present, they may be the same or different and may be combined together to form a ring together with atoms to which they are attached.

**2.** The composition for light emitting device according to Claim 1, wherein
said condensed ring skeleton is a condensed ring skeleton in which only three or more and five or less benzene rings are condensed.

**3.** The composition for light emitting device according to Claim 2, wherein
said condensed ring skeleton is an anthracene skeleton, a phenanthrene skeleton, a benzoanthracene skeleton, a benzophenanthrene skeleton or a pyrene skeleton.

**4.** The composition for light emitting device according to any one of Claims 1 to 3, wherein said heterocyclic group is a heterocyclic group containing a carbon atom and a nitrogen atom in the ring.

**5.** The composition for light emitting device according to any one of Claims 1 to 4, wherein said heterocyclic group is a heterocyclic group obtained by removing from a monocyclic or bicyclic to pentacyclic heterocyclic compound one or more hydrogen atoms bonding directly to atoms constituting the ring.

**6.** The composition for light emitting device according to any one of Claims 1 to 5, wherein said heterocyclic group is a heterocyclic group obtained by removing from pyridine, diazabenzene, triazine, carbazole, benzocarbazole, dibenzocarbazole, indolocarbazole or indenocarbazole one or more hydrogen atoms bonding directly to atoms constituting the ring.

**7.** The composition for light emitting device according to any one of Claims 1 to 6, further containing at least one selected from the group consisting of a hole transporting material, a hole injection material, an electron transporting material, an electron injection material, a light emitting material, an antioxidant and a solvent.

**8.** A light emitting device having an anode, a cathode, and an organic layer disposed between said anode and said cathode, wherein
said organic layer is a layer containing the composition for light emitting device as described in any one of Claims 1 to 7.

**9.** A method for producing a composition for light emitting device containing a host material and a guest material blended therein, comprising

a host material preparation step of preparing a host material containing an aromatic compound having a condensed ring skeleton in which only three or more benzene rings are condensed,
a guest material preparation step of preparing a guest material containing a compound having a heterocyclic group containing a carbon atom and at least one selected from the group consisting of a boron atom, a nitrogen atom, a phosphorus atom, an oxygen atom, a sulfur atom and a selenium atom in the ring, and

a production step of mixing said host material and said guest material at a blending ratio such that the total amount of silicon atoms contained in said host material and silicon atoms contained in said guest material is 7 ppm by mass or more and 28 ppm by mass or less to obtain a composition for light emitting device; and

(a) said aromatic compound having a condensed ring skeleton in which only three or more benzene rings are condensed is a compound represented by the formula (FH) :

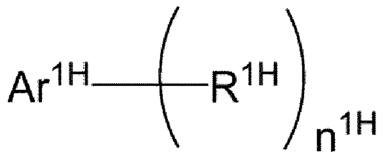
(FH)

wherein,

$n^{1H}$ represents an integer of 0 or more,
$Ar^{1H}$ represents a group obtained by removing from an aromatic hydrocarbon having a condensed ring skeleton in which only three or more benzene rings are condensed $n^{1H}$ or more hydrogen atoms bonding directly to carbon atoms constituting said condensed ring skeleton, and this group optionally has a substituent, when a plurality of the substituents are present, they may be the same or different and may be combined together to form a ring together with atoms to which they are attached,
$R^{1H}$ represents an aryl group or a monovalent heterocyclic group, and these groups optionally have a substituent, when a plurality of the substituents are present, they may be the same or different and may be combined together to form a ring together with atoms to which they are attached, when a plurality of $R^{1H}$ are present, they may be the same or different and may be combined together to form a ring together with atoms to which they are attached; and

(b) said compound having the heterocyclic group is a compound represented by the formula (FB):

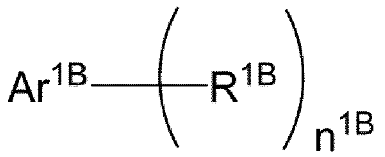
(FB)

wherein,

$n^{1B}$ represents an integer of 0 or more.
$Ar^{1B}$ represents a group obtained by removing from a compound having a heterocyclic ring containing a carbon atom and at least one selected from the group consisting of a boron atom, a nitrogen atom, a phosphorus atom, an oxygen atom, a sulfur atom and a selenium atom in the ring $n^{1B}$ or more hydrogen atoms bonding directly to atoms constituting the above-described heterocyclic ring, and this group optionally has a substituent, when a plurality of the substituents are present, they may be the same or different and may be combined together to form a ring together with atoms to which they are attached.
$R^{1B}$ represents a halogen atom, an alkyl group, a cycloalkyl group, an alkoxy group, a cycloalkoxy group, an aryloxy group, an aryl group, a monovalent heterocyclic group or a substituted amino group, and these groups optionally have a substituent, when a plurality of the substituents are present, they may be the same or different and may be combined together to form a ring together with atoms to which they are attached, when a plurality of $R^{1B}$ are present, they may be the same or different and may be combined together to form a ring together with atoms to which they are attached.

**10.** The production method according to Claim 9, wherein
said host material preparation step comprises

a step (A-1) of preparing said aromatic compound having a condensed ring skeleton in which only three or more benzene rings are condensed containing silicon atoms mixed therein, and
a step (A-2) of purifying at least a part of said aromatic compound having a condensed ring skeleton in which only

three or more benzene rings are condensed prepared in said step (A-1) to remove at least a part of said silicon atoms.

**11.** The production method according to Claim 9 or 10, wherein said guest material preparation step comprises

a preparation step (B-1) of preparing said compound having the heterocyclic group containing silicon atoms mixed therein, and
a step (B-2) of purifying at least a part of said compound having the heterocyclic group prepared in said step (B-1) to remove at least a part of said silicon atoms.

**12.** A method for producing a composition for light emitting device containing a host material and a guest material blended therein, comprising:

(a) a host material preparation step of preparing a host material containing an aromatic compound having a condensed ring skeleton in which only three or more benzene rings are condensed,

a determination step of determining the blending ratio of the guest material to said host material,
a guest material preparation step of preparing a guest material which contains a compound having a heterocyclic group containing a carbon atom and at least one selected from the group consisting of a boron atom, a nitrogen atom, a phosphorus atom, an oxygen atom, a sulfur atom and a selenium atom in the ring and with which, when mixed with said host material at said blending ratio, the total amount of silicon atoms contained in said host material and silicon atoms contained in said guest material with respect to the total amount of said host material and said guest material is 7 ppm by mass or more and 28 ppm by mass or less, and
a production step of mixing said host material and said guest material at said blending ratio to obtain a composition for light emitting device; or

(b) a guest material preparation step of preparing a guest material containing a compound having a heterocyclic group containing a carbon atom and at least one selected from the group consisting of a boron atom, a nitrogen atom, a phosphorus atom, an oxygen atom, a sulfur atom and a selenium atom in the ring,

a determination step of determining the blending ratio of the host material to said guest material,
a host material preparation step of preparing a host material which contains an aromatic compound having a condensed ring skeleton in which only three or more benzene rings are condensed and with which, when mixed with said guest material at said blending ratio, the total amount of silicon atoms contained in said host material and silicon atoms contained in said guest material with respect to the total amount of said host material and said guest material is 7 ppm by mass or more and 28 ppm by mass or less, and
a production step of mixing said guest material and said host material at said blending ratio to obtain a composition for light emitting device; or

(c) a host material preparation step of preparing an aromatic compound having a condensed ring skeleton in which only three or more benzene rings are condensed as the host material,

a guest material preparation step of preparing a compound having a heterocyclic group containing a carbon atom and at least one selected from the group consisting of a boron atom, a nitrogen atom, a phosphorus atom, an oxygen atom, a sulfur atom and a selenium atom in the ring, as the guest material,
a determination step of determining the blending ratio of said host material and said guest material,
a purification step of purifying at least a part of said aromatic compound having a condensed ring skeleton in which only three or more benzene rings are condensed and said compound having the heterocyclic group so that when said host material and said guest material are mixed at said blending ratio, the total amount of silicon atoms contained in said host material and silicon atoms contained in said guest material with respect to the total amount of said host material and said guest material is 7 ppm by mass or more and 28 ppm by mass or less, and
a production step of mixing said host material containing said aromatic compound having a condensed ring skeleton in which only three or more benzene rings are condensed and said guest material containing said compound having the heterocyclic group at said blending ratio to obtain a composition for light emitting device; wherein, for each of the above (a) to (c),

(i) said aromatic compound having a condensed ring skeleton in which only three or more benzene rings are condensed is a compound represented by the formula (FH) :

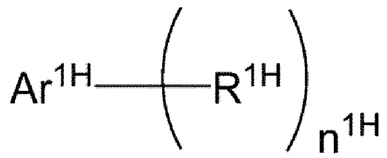

(FH)

wherein,

$n^{1H}$ represents an integer of 0 or more,
$Ar^{1H}$ represents a group obtained by removing from an aromatic hydrocarbon having a condensed ring skeleton in which only three or more benzene rings are condensed $n^{1H}$ or more hydrogen atoms bonding directly to carbon atoms constituting said condensed ring skeleton, and this group optionally has a substituent, when a plurality of the substituents are present, they may be the same or different and may be combined together to form a ring together with atoms to which they are attached,
$R^{1H}$ represents an aryl group or a monovalent heterocyclic group, and these groups optionally have a substituent, when a plurality of the substituents are present, they may be the same or different and may be combined together to form a ring together with atoms to which they are attached, when a plurality of $R^{1H}$ are present, they may be the same or different and may be combined together to form a ring together with atoms to which they are attached; and

(ii) said compound having the heterocyclic group is a compound represented by the formula (FB):

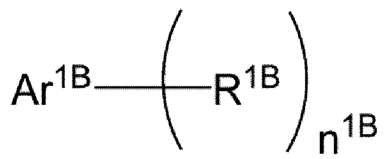

(FB)

wherein,

$n^{1B}$ represents an integer of 0 or more.
$Ar^{1B}$ represents a group obtained by removing from a compound having a heterocyclic ring containing a carbon atom and at least one selected from the group consisting of a boron atom, a nitrogen atom, a phosphorus atom, an oxygen atom, a sulfur atom and a selenium atom in the ring $n^{1B}$ or more hydrogen atoms bonding directly to atoms constituting the above-described heterocyclic ring, and this group optionally has a substituent, when a plurality of the substituents are present, they may be the same or different and may be combined together to form a ring together with atoms to which they are attached.
$R^{1B}$ represents a halogen atom, an alkyl group, a cycloalkyl group, an alkoxy group, a cycloalkoxy group, an aryloxy group, an aryl group, a monovalent heterocyclic group or a substituted amino group, and these groups optionally have a substituent, when a plurality of the substituents are present, they may be the same or different and may be combined together to form a ring together with atoms to which they are attached, when a plurality of $R^{1B}$ are present, they may be the same or different and may be combined together to form a ring together with atoms to which they are attached.

**13.** The production method according to any one of Claims 9 to 12, further comprising

a host material measurement step of measuring the content of silicon atoms contained in said aromatic compound having a condensed ring skeleton in which only three or more benzene rings are condensed, and
a guest material measurement step of measuring the content of silicon atoms contained in said compound having a heterocyclic group containing a carbon atom and at least one selected from the group consisting of a boron atom, a nitrogen atom, a phosphorus atom, an oxygen atom, a sulfur atom and a selenium atom in the ring.

**14.** A method for producing a light emitting device containing an anode, a cathode, and an organic layer disposed between said anode and said cathode, comprising

a step of forming said organic layer with the composition for light emitting device produced by the production method as described in any one of Claims 9 to 13.

## Patentansprüche

**1.** Zusammensetzung für eine lichtemittierende Vorrichtung, die ein Wirtsmaterial und ein damit gemischtes Gastmaterial enthält, wobei

das Gastmaterial eine aromatische Verbindung mit einem kondensierten Ringskelett enthält, in dem nur drei oder mehr Benzolringe kondensiert werden,
das Gastmaterial enthält eine Verbindung mit einer heterozyklischen Gruppe, die ein Kohlenstoffatom und mindestens eines ausgewählt aus der Gruppe bestehend aus Boratom, Stickstoffatom, Posphoratom, Sauerstoffatom, Schwefelatom und Selenatom in dem Ring enthält, und
wobei die Gesamtmenge der Siliziumatome, die in dem Wirtsmaterial enthalten sind, und der Siliziumatome, die in dem Gastmaterial enthalten sind, 7 ppm nach Masse oder mehr und 28 ppm nach Masse oder weniger bezogen auf die Gesamtmenge des Wirtsmaterials und des Gastmaterials beträgt, und wobei:

(a) die aromatische Verbindung, die ein kondensiertes Ringskelett aufweist, in dem nur drei oder mehr Benzolringe kondensiert sind, eine Verbindung ist, die von der Formel (FH) repräsentiert wird:

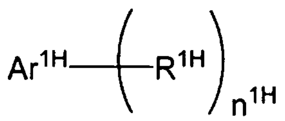
(FH)

wobei gilt

$n^{1H}$ repräsentiert eine ganze Zahl von 0 oder mehr,
$Ar^{1H}$ repräsentiert eine Gruppe, die erhalten wird, indem aus einem aromatischen Kohlenwasserstoff mit einem kondensierten Ringskelett, in dem nur drei oder mehr Benzolringe kondensiert sind, $n^{1H}$ oder mehr Wasserstoffatome entfernt werden, die direkt an die Kohlenstoffatome gebunden sind, die das kondensierte Ringskelett bilden, und diese Gruppe optional einen Substituenten aufweist, wobei, wenn eine Vielzahl der Substituenten vorhanden ist, diese gleich oder verschieden sein können und sich mit den Atomen, an die sie gebunden sind, zu einem Ring verbinden können,
$R^{1H}$ repräsentiert eine Aryl-Gruppe oder eine monovalente heterozyklische Gruppe, und diese Gruppen weisen optional einen Substituenten auf, wenn eine Vielzahl der Substituenten vorhanden ist, können sie gleich oder verschieden sein und sich mit den Atomen, an die sie gebunden sind, zu einem Ring verbinden, wobei, wenn eine Vielzahl von $R^{1H}$ vorhanden ist, diese gleich oder verschieden sein können und sich mit den Atomen, an die sie gebunden sind, zu einem Ring verbinden können; und

(b) die Verbinndung, die die heterozyklische Gruppe aufweist, ist eine Verbindung, die durch folgende Formel (FB) repräsentiert wird:

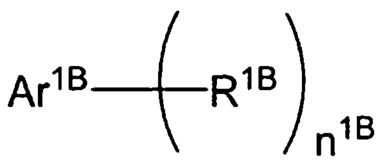
(FB)

wobei gilt

$n^{1B}$ repräsentiert eine ganze Zahl von 0 oder mehr.
$Ar^{1B}$ repräsentiert eine Gruppe, die erhalten wird, indem aus einer Verbindung mit einem heterozyklischen Ring, der ein Kohlenstoffatom und mindestens eines aus der Gruppe bestehend aus einem Boratom, einem Stickstoffatom, einem Phosphoratom, einem Sauerstoffatom, einem Schwefelatom und einem Selenatom im Ring enthält, $n^1$B oder mehr Wasserstoffatome, die direkt an Atome gebunden

sind, die den oben beschriebenen heterozyklischen Ring bilden, entfernt wird, und diese Gruppe optional einen Substituenten aufweist, wobei, wenn eine Vielzahl von Substituenten vorhanden sind, diese gleich oder verschieden sein können und sich mit den Atomen, an die sie gebunden sind, zu einem Ring verbinden können.
$R^{1B}$ repräsentiert ein Halogenatom, eine Alkylgruppe, eine Cycloalkylgruppe, eine Alkoxygruppe, eine Cycloalkoxygruppe, eine Aryloxygruppe, eine Arylgruppe, eine monovalente heterozyklische Gruppe oder eine substituierte Aminogruppe, und diese Gruppen können optional einen Substituenten aufweisen, wobei, wenn mehrere Substituenten vorhanden sind, diese gleich oder verschieden sein können und sich mit den Atomen, an die sie gebunden sind, zu einem Ring verbinden können, wobei, wenn eine Vielzahl von $R^{1B}$vorhanden ist, diese gleich oder verschieden sein können und sich mit den Atomen, an die sie gebunden sind, zu einem Ring verbinden können.

**2.** Zusammensetzung für eine lichtemittierende Vorrichtung nach Anspruch 1, wobei
das kondensierten Ringskelett ein kondensiertes Ringskelett ist, in dem nur drei oder mehr und fünf oder weniger Ringe kondensiert sind.

**3.** Zusammensetzung für eine lichtemittierende Vorrichtung nach Anspruch 2, wobei
das kondensierte Ringskelett ein Anthracen-Skelett, ein Phenanthren-Skelett, ein Benzoanthracen-Skelett, ein Benzophenanthren-Skelett oder ein Pyren-Skelett ist.

**4.** Zusammensetzung für eine lichtemittierende Vorrichtung nach einem der Ansprüche 1 bis 3, wobei die heterozyklische Gruppe eine heterozyklische Gruppe ist, die ein Kohlenstoffatom und ein Stickstoffatom in dem Ring enthält.

**5.** Zusammensetzung für eine lichtemittierende Vorrichtung nach einem der Ansprüche 1 bis 4, wobei die heterozyklische Gruppe eine heterozyklische Gruppe ist, die durch Entfernen aus einer monozyklischen oder bizyklischen bis pentazyklischen, heterozyklischen Verbindung eines oder mehrerer Wasserstoffatome, die direkt an Atome gebunden sind, die den Ring bilden, erhalten wird.

**6.** Zusammensetzung für eine lichtemittierende Vorrichtung nach einem der Ansprüche 1 bis 5, wobei die heterozyklische Gruppe eine heterozyklische Gruppe ist, die erhalten wird, indem aus Pyridin, Diazobenzol, Triazin, Carbazol, Benzocarbazol, Dibenzocarbazol, Indolocarbazol oder Indenocarbazol ein oder mehr Wasserstoffatome, die direkt an Atome gebunden sind, die den Ring bilden, entfernt werden.

**7.** Zusammensetzung für eine lichtemittierende Vorrichtung nach einem der Ansprüche 1 bis 6, die ferner mindestens eines ausgewählt aus der Gruppe bestehend aus einem Lochtransportmaterial, Lochinjektionsmaterial, Elektronentransportmaterial, Elektroneninjektionsmaterial, einem lichtemittierenden Material, Antioxidationsmittel und Lösungsmittel enthält.

**8.** Lichtemittierende Vorrichtung, die eine Anode, eine Kathode und eine organische Schicht, die zwischen der Anode und der Kathode angeordnet ist, aufweist, wobei
die organische Schicht eine Schicht ist, die die Zusammensetzung für eine lichtemittierende Vorrichtung enthält, wie sie in einem der Ansprüche 1 bis 7 beschrieben ist.

**9.** Verfahren für das Herstellen einer Zusammensetzung für eine lichtemittierende Vorrichtung, die ein Wirtsmaterial und ein damit gemischtes Gastmaterial enthält, umfassend

einen Wirtsmaterial-Vorbereitungsschritt zum Vorbereiten eines Gastmaterials, das eine aromatische Verbindung mit einem kondensierten Ringskelett aufweist, in dem nur drei oder mehr Benzolringe kondensiert werden,
einen Gastmaterial-Vorbereitungsschritt zum Vorbereiten eines Gastmaterials, das eine Verbindung mit einer heterozyklischen Gruppe enthält, die ein Kohlenstoffatom und mindestens eines ausgewählt aus der Gruppe bestehend aus Boratom, Stickstoffatom, Posphoratom, Sauerstoffatom, Schwefelatom und Selenatom in dem Ring enthält, und
einen Produktionsschritt zum Mischen des Wirtsmaterials und des Gastmaterials in einem Mischverhältnis, so dass die Gesamtmenge der in dem Wirtsmaterial enthaltenen Siliziumatome und die in dem Gastmaterial enthaltenen Siliziumatome 7 ppm nach Masse oder mehr und 28 ppm nach Masse oder weniger beträgt, um eine Zusammensetzung für eine lichtemittierende Vorrichtung zu erhalten; und

(a) die aromatische Verbindung, die ein kondensiertes Ringskelett aufweist, in dem nur drei oder mehr Benzolringe kondensiert sind, eine Verbindung ist, die von der Formel (FH) repräsentiert wird:

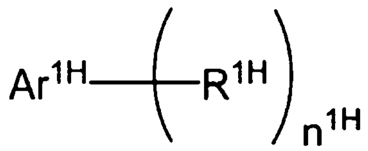

(FH)

wobei gilt

$n^{1H}$ repräsentiert eine ganze Zahl von 0 oder mehr,
$Ar^{1H}$ repräsentiert eine Gruppe, die erhalten wird, indem aus einem aromatischen Kohlenwasserstoff mit einem kondensierten Ringskelett, in dem nur drei oder mehr Benzolringe kondensiert sind, $n^{1H}$ oder mehr Wasserstoffatome entfernt werden, die direkt an die Kohlenstoffatome gebunden sind, die das kondensierte Ringskelett bilden, und diese Gruppe optional einen Substituenten aufweist, wobei, wenn eine Vielzahl von Substituenten vorhanden ist, diese gleich oder verschieden sein können und sich mit den Atomen, an die sie gebunden sind, zu einem Ring verbinden können,
$R^{1H}$ repräsentiert eine Aryl-Gruppe oder eine monovalente heterozyklische Gruppe, und diese Gruppen weisen optional einen Substituenten auf, wobei, wenn eine Vielzahl der Substituenten vorhanden ist, diese gleich oder verschieden sein können und sich mit den Atomen, an die sie gebunden sind, zu einem Ring verbinden können, wobei, wenn eine Vielzahl von $R^{1H}$ vorhanden ist, diese gleich oder verschieden sein können und sich mit den Atomen, an die sie gebunden sind, zu einem Ring verbinden können; und

(b) die Verbindung, die die heterozyklische Gruppe aufweist, eine Verbindung ist, die durch die Formel (FB) repräsentiert ist:

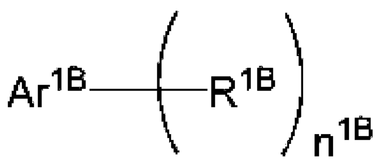

(FB)

wobei gilt

$n^{1B}$ repräsentiert eine ganze Zahl von 0 oder mehr.
$Ar^{1B}$ repräsentiert eine Gruppe, die erhalten wird, indem aus einer Verbindung mit einem heterozyklischen Ring, der ein Kohlenstoffatom und mindestens eines aus der Gruppe bestehend aus einem Boratom, einem Stickstoffatom, einem Phosphoratom, einem Sauerstoffatom, einem Schwefelatom und einem Selenatom im Ring enthält, $n^{1B}$ oder mehr Wasserstoffatome, die direkt an Atome gebunden sind, die den oben beschriebenen heterozyklischen Ring bilden, entfernt wird, und diese Gruppe optional einen Substituenten aufweist, wobei, wenn eine Vielzahl der Substituenten vorhanden sind, diese gleich oder verschieden sein können und sich mit den Atomen, an die sie gebunden sind, zu einem Ring verbinden können,
$R^{1B}$ repräsentiert ein Halogenatom, eine Alkylgruppe, eine Cycloalkylgruppe, eine Alkoxygruppe, eine Cycloalkoxygruppe, eine Aryloxygruppe, eine Arylgruppe, eine monovalente heterozyklische Gruppe oder eine substituierte Aminogruppe, und diese Gruppen können optional einen Substituenten aufweisen, wobei, wenn eine Vielzahl der Substituenten vorhanden ist, diese gleich oder verschieden sein können und sich mit den Atomen, an die sie gebunden sind, zu einem Ring verbinden können, wobei, wenn eine Vielzahl von $R^{1B}$vorhanden ist, diese gleich oder verschieden sein können und sich mit den Atomen, an die sie gebunden sind, zu einem Ring verbinden können.

**10.** Produktionsverfahren nach Anspruch 9, der Wirtsmaterial-Vorbereitungsschritt umfassend

einen Schritt (A-1) zum Vorbereiten der aromatischen Verbindung, die ein kondensiertes Ringskelett aufweist, in dem nur drei oder mehr Benzolringe kondensiert sind, die darin gemischte Siliziumatome enthalten, und
einen Schritt (A-2) zum Reinigen mindestens eines Teils der aromatischen Verbindung mit einem kondensierten

Ringskelett, in dem nur drei oder mehr Benzolringe kondensiert sind, die in Schritt (A-1) vorbereitet wurden, um mindestens einen Teil der Siliziumatome zu entfernen.

**11.** Produktionsverfahren nach Anspruch 9 oder 10, der Gastmaterial-Vorbereitungsschritt umfassend

einen Vorbereitungsschritt (B-1) zum Vorbereiten der Verbindung mit der heterozyklischen Gruppe, die darin gemischte Siliziumatome enthält, und
einen Schritt (B-2) zum Reinigen mindestens eines Teils der Verbindung mit der heterozyklischen Gruppe, die in Schritt (B-1) vorbereitet wurde, um mindestens einen Teil der Siliziumatome zu entfernen.

**12.** Verfahren für das Herstellen einer Zusammensetzung für eine lichtemittierende Vorrichtung, die ein Wirtsmaterial und ein damit gemischtes Gastmaterial enthält, umfassend:

(a) einen Wirtsmaterial-Vorbereitungsschritt zum Vorbereiten eines Wirtsmaterials, das eine aromatische Verbindung mit einem kondensierten Ringskelett aufweist, in dem nur drei oder mehr Benzolringe kondensiert werden,

einen Bestimmungsschritt zum Bestimmen des Mischverhältnisses des Gastmaterials mit dem Wirtsmaterial,
einen Gastmaterial-Vorbereitungsschritt zum Vorbereiten eines Gastmaterials, das eine Verbindung mit einer heterozyklischen Gruppe enthält, die ein Kohlenstoffatom und mindestens eines ausgewählt aus der Gruppe bestehend aus einem Boratom, Stickstoffatom, Posphoratom, Sauerstoffatom, Schwefelatom und Selenatom in dem Ring enthält und mit dem, wenn es mit dem Wirtsmaterial in dem Mischverhältnis gemischt wird, die Gesamtmenge der in dem Wirtsmaterial enthaltenen Siliziumatome und der in dem Gastmaterial enthaltenen Siliziumatome im Verhältnis zu der Gesamtmenge des Wirtsmaterials und des Gastmaterials 7 ppm nach Masse oder mehr und 28 ppm nach Masse oder weniger beträgt, und
einen Produktionsschritt zum Mischen des Wirtsmaterials und des Gastmaterials in dem Mischverhältnis, um eine Zusammensetzung für eine lichtemittierende Vorrichtung zu erhalten; oder

(b) einen Gastmaterial-Vorbereitungsschritt zum Vorbereiten eines Gastmaterials, das eine Verbindung mit einer heterozyklischen Gruppe enthält, die ein Kohlenstoffatom und mindestens eines ausgewählt aus der Gruppe bestehend aus Boratom, Stickstoffatom, Posphoratom, Sauerstoffatom, Schwefelatom und Selenatom in dem Ring enthält,

einen Bestimmungsschritt zum Bestimmen des Mischverhältnisses des Wirtsmaterials mit dem Gastmaterial,
einen Wirtsmaterial-Vorbereitungsschritt zum Vorbereiten eines Wirtsmaterials, das eine aromatische Verbindung mit einem kondensierten Ringskelett enthält, in dem nur drei oder mehr Benzolringe kondensiert sind, in dem, wenn es mit dem Gastmaterial in dem Mischverhältnis gemischt wird, die Gesamtmenge der in dem Wirtsmaterial enthaltenen Siliziumatome und der in dem Gastmaterial enthaltenen Siliziumatome im Verhältnis zu der Gesamtmenge des Wirtsmaterials und des Gastmaterials 7 ppm nach Masse oder mehr und 28 ppm nach Masse oder weniger beträgt, und
einen Produktionsschritt zum Mischen des Gastmaterials und des Wirtsmaterials in dem Mischverhältnis, um eine Zusammensetzung für eine lichtemittierende Vorrichtung zu erhalten; oder

(c) einen Wirtsmaterial-Vorbereitungsschritt zum Vorbereiten einer aromatischen Verbindung mit einem kondensierten Ringskelett, in dem nur drei oder mehr Benzolringe als Wirtsmaterial kondensiert werden,

einen Gastmaterial-Vorbereitungsschritt zum Vorbereiten einer Verbindung mit einer heterozyklischen Gruppe, die ein Kohlenstoffatom und mindestens eines ausgewählt aus der Gruppe bestehend aus Boratom, Stickstoffatom, Posphoratom, Sauerstoffatom, Schwefelatom und Selenatom in dem Ring als Gastmaterial enthält,
einen Bestimmungsschritt zum Bestimmen des Mischverhältnisses des Wirtsmaterials und des Gastmaterials,
einen Reinigungsschritt zum Reinigen mindestens eines Teils der aromatische Verbindung mit einem kondensierten Ringskelett, in dem nur drei oder mehr Benzolringe kondensiert sind und die Verbindung die heterozyklische Gruppe aufweist, so dass, wenn das Wirtsmaterial mit dem Gastmaterial in dem Mischungsverhältnis gemischt wird, die Gesamtmenge der in dem Wirtsmaterial enthaltenen Siliziumatome

und der in dem Gastmaterial enthaltenen Siliziumatome im Verhältnis zu der Gesamtmenge des Wirtsmaterials und des Gastmaterials 7 ppm nach Masse oder mehr und 28 ppm nach Masse oder weniger beträgt, und

einen Produktionsschritt zum Mischen des Wirtmaterials, das die aromatische Verbindung mit einem kondensierten Ringskelett enthält, in dem nur drei oder mehr Benzolringe kondensiert sind und das Gastmaterial, das die Verbindung enthält, die heterozyklische Gruppe in dem Mischverhältnis aufweist, um eine Zusammensetzung für eine lichtemittierende Vorrichtung zu erhalten; wobei für die oben genannten (a) bis (c),

(i) die aromatische Verbindung, die ein kondensiertes Ringskelett aufweist, in dem nur drei oder mehr Benzolringe kondensiert sind, eine Verbindung ist, die von der Formel (FH) repräsentiert wird:

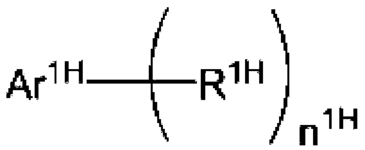

(FH)

wobei gilt

$n^{1H}$ repräsentiert eine ganze Zahl von 0 oder mehr,

$Ar^{1H}$ repräsentiert eine Gruppe, die erhalten wird, indem aus einem aromatischen Kohlenwasserstoff mit einem kondensierten Ringskelett, in dem nur drei oder mehr Benzolringe kondensiert sind, $n^{1H}$ oder mehr Wasserstoffatome entfernt werden, die direkt an die Kohlenstoffatome gebunden sind, die das kondensierte Ringskelett bilden, und diese Gruppe optional einen Substituenten aufweist, wobei, wenn eine Vielzahl von Substituenten vorhanden ist, diese gleich oder verschieden sein können und sich mit den Atomen, an die sie gebunden sind, zu einem Ring verbinden können,

$R^{1H}$ repräsentiert eine Aryl-Gruppe oder eine monovalente heterozyklische Gruppe, und diese Gruppen weisen optional einen Substituenten auf, wobei, wenn eine Vielzahl der Substituenten vorhanden ist, diese gleich oder verschieden sein können und sich mit den Atomen, an die sie gebunden sind, zu einem Ring verbinden können, wobei, wenn eine Vielzahl von $R^{1H}$ vorhanden ist, diese gleich oder verschieden sein können und sich mit den Atomen, an die sie gebunden sind, zu einem Ring verbinden können; und

(ii) die Verbindung, die die heterozyklische Gruppe aufweist, eine Verbindung ist, die durch die Formel (FB) repräsentiert ist:

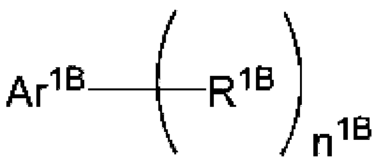

(FB)

wobei gilt

$n^{1B}$ repräsentiert eine ganze Zahl von 0 oder mehr.

$Ar^{1B}$ repräsentiert eine Gruppe, die erhalten wird, indem aus einer Verbindung mit einem heterozyklischen Ring, der ein Kohlenstoffatom und mindestens eines aus der Gruppe bestehend aus einem Boratom, einem Stickstoffatom, einem Phosphoratom, einem Sauerstoffatom, einem Schwefelatom und einem Selenatom im Ring enthält, $n^{1B}$ oder mehr Wasserstoffatome, die direkt an Atome gebunden sind, die den oben beschriebenen heterozyklischen Ring bilden, entfernt wird, und diese Gruppe optional einen Substituenten aufweist, wobei, wenn eine Vielzahl der Substituenten vorhanden ist, diese gleich oder verschieden sein können und sich mit den Atomen, an die sie gebunden sind, zu einem Ring verbinden können.

$R^{1B}$ repräsentiert ein Halogenatom, eine Alkylgruppe, eine Cycloalkylgruppe, eine Alkoxygruppe, eine Cycloalkoxygruppe, eine Aryloxygruppe, eine Arylgruppe, eine monovalente heterozyklische Gruppe oder eine substituierte Aminogruppe, und diese Gruppen können optional einen Substituenten aufweisen, wobei, wenn eine Vielzahl von Substituenten vorhanden ist, diese gleich oder verschieden sein können und sich mit den Atomen, an die sie gebunden sind, zu einem Ring verbinden können, wobei, wenn eine Vielzahl von $R^{1B}$

vorhanden ist, diese gleich oder verschieden sein können und sich mit den Atomen, an die sie gebunden sind, zu einem Ring verbinden können.

**13.** Produktionsverfahren nach einem der Ansprüche 9 bis 12, ferner umfassend

einen Wirtsmaterial-Messschritt zum Messen des Anteils an Siliziumatomen, die in der aromatischen Verbindung mit einem kondensierten Ringskelett enthalten sind, in dem nur drei oder mehr Benzolringe kondensiert sind, und einen Gastmaterial-Messschritt zum Messen des Anteils an Siliziumatomen, die in der Verbindung mit einer heterozyklischen Gruppe enthalten sind, die ein Kohlenstoffatom und mindestens eines ausgewählt aus der Gruppe bestehend aus Boratom, Stickstoffatom, Posphoratom, Sauerstoffatom, Schwefelatom und Selenatom in dem Ring enthält.

**14.** Verfahren für das Herstellen einer lichtemittierenden Vorrichtung, die eine Anode, eine Kathode und eine organische Schicht enthält, die zwischen der Anode und der Kathode angeordnet ist, umfassend
einen Schritt zum Bilden der organischen Schicht mit der Zusammensetzung für die lichtemittierende Vorrichtung, die nach den Produktionsverfahren hergestellt ist, die in einem der Ansprüche 9 bis 13 beschrieben ist.

## Revendications

**1.** Composition pour dispositif électroluminescent contenant un matériau hôte et un matériau invité mélangés dans celle-ci, dans laquelle

ledit matériau hôte contient un composé aromatique présentant un squelette de cycle condensé dans lequel seuls au moins trois cycles benzène sont condensés,
ledit matériau invité contient un composé présentant un groupe hétérocyclique contenant un atome de carbone et au moins un élément choisi dans le groupe constitué d'un atome de bore, d'un atome d'azote, d'un atome de phosphore, d'un atome d'oxygène, d'un atome de soufre et d'un atome de sélénium dans le cycle, et
la quantité totale d'atomes de silicium contenus dans ledit matériau hôte et d'atomes de silicium contenus dans ledit matériau invité est supérieure ou égale à 7 ppm en masse et inférieure ou égale à 28 ppm en masse par rapport à la quantité totale dudit matériau hôte et dudit matériau invité, et dans laquelle :

(a) ledit composé aromatique présentant un squelette de cycle condensé dans lequel seuls au moins trois cycles benzène sont condensés est un composé représenté par la formule (FH) :

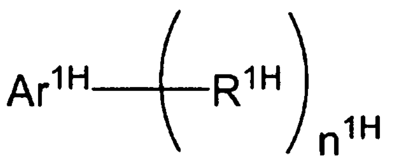
(FH)

où,

$n^{1H}$ représente un nombre entier égal ou supérieur à 0,
$Ar^{1H}$ représente un groupe obtenu par élimination à partir d'un hydrocarbure aromatique présentant un squelette de cycle condensé dans lequel seuls au moins trois cycles benzène sont condensés, d'au moins $n^{1H}$ atomes d'hydrogène liés directement aux atomes de carbone constituant ledit squelette de cycle condensé, et ce groupe présente éventuellement un substituant, lorsqu'une pluralité des substituants sont présents, ils peuvent être identiques ou différents et peuvent être combinés ensemble pour former un cycle conjointement avec des atomes auxquels ils sont attachés,
$R^{1H}$ représente un groupe aryle ou un groupe hétérocyclique monovalent, et ces groupes présentent éventuellement un substituant, lorsqu'une pluralité de substituants sont présents, ils peuvent être identiques ou différents et peuvent être combinés ensemble pour former un cycle conjointement avec les atomes auxquels ils sont attachés, lorsqu'une pluralité de $R^{1H}$ sont présents, ils peuvent être identiques ou différents et peuvent être combinés ensemble pour former un cycle conjointement avec des atomes auxquels ils sont attachés ; et

(b) ledit composé présentant le groupe hétérocyclique est un composé représenté par la formule (FB) :

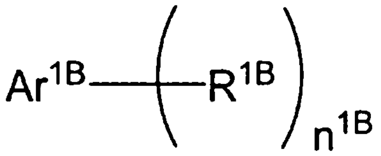 (FB)

où,

$n^{1B}$ représente un nombre entier égal ou supérieur à 0.
$Ar^{1B}$ représente un groupe obtenu par élimination à partir d'un composé présentant un cycle hétérocyclique contenant un atome de carbone et au moins un atome choisi dans le groupe constitué d'un atome de bore, d'un atome d'azote, d'un atome de phosphore, d'un atome d'oxygène, d'un atome de soufre et d'un atome de sélénium dans le cycle d'au moins $n^{1B}$ atomes d'hydrogène liés directement à des atomes constituant le cycle hétérocyclique décrit ci-dessus, et ce groupe présente éventuellement un substituant, lorsqu'une pluralité de substituants sont présents, ils peuvent être identiques ou différents et peuvent être combinés ensemble pour former un cycle conjointement avec des atomes auxquels ils sont attachés.
$R^{1B}$ représente un atome d'halogène, un groupe alkyle, un groupe cycloalkyle, un groupe alcoxy, un groupe cycloalcoxy, un groupe aryloxy, un groupe aryle, un groupe hétérocyclique monovalent ou un groupe amino substitué, et ces groupes présentent éventuellement un substituant, lorsqu'une pluralité de substituants sont présents, ils peuvent être identiques ou différents et peuvent être combinés ensemble pour former un cycle conjointement avec des atomes auxquels ils sont attachés, lorsqu'une pluralité de $R^{1B}$ sont présents, ils peuvent être identiques ou différents et peuvent être combinés ensemble pour former un cycle conjointement avec des atomes auxquels ils sont attachés.

**2.** Composition pour dispositif électroluminescent selon la revendication 1, dans laquelle
ledit squelette de cycle condensé est un squelette de cycle condensé dans lequel seuls au moins trois et au plus cinq cycles benzène sont condensés.

**3.** Composition pour dispositif électroluminescent selon la revendication 2, dans laquelle
ledit squelette de cycle condensé est un squelette d'anthracène, un squelette de phénanthrène, un squelette de benzoanthracène, un squelette de benzophénanthrène ou un squelette de pyrène.

**4.** Composition pour dispositif électroluminescent selon l'une quelconque des revendications 1 à 3, dans laquelle ledit groupe hétérocyclique est un groupe hétérocyclique contenant un atome de carbone et un atome d'azote dans le cycle.

**5.** Composition pour dispositif électroluminescent selon l'une quelconque des revendications 1 à 4, dans laquelle ledit groupe hétérocyclique est un groupe hétérocyclique obtenu par élimination à partir d'un composé hétérocyclique monocyclique ou bicyclique à pentacyclique d'un ou de plusieurs atomes d'hydrogène liés directement à des atomes constituant le cycle.

**6.** Composition pour dispositif électroluminescent selon l'une quelconque des revendications 1 à 5, dans laquelle ledit groupe hétérocyclique est un groupe hétérocyclique obtenu par élimination à partir de pyridine, diazobenzène, triazine, carbazole, benzocarbazole, dibenzocarbazole, indolocarbazole ou indénocarbazole d'un ou de plusieurs atomes d'hydrogène liés directement à des atomes constituant le cycle.

**7.** Composition pour dispositif électroluminescent selon l'une quelconque des revendications 1 à 6, contenant en outre au moins un élément choisi dans le groupe constitué d'un matériau de transport de trous, d'un matériau d'injection de trous, d'un matériau de transport d'électrons, d'un matériau d'injection d'électrons, d'un matériau électroluminescent, d'un antioxydant et d'un solvant.

**8.** Dispositif électroluminescent présentant une anode, une cathode, et une couche organique disposée entre ladite anode et ladite cathode, dans lequel
ladite couche organique est une couche contenant la composition pour dispositif électroluminescent telle que décrite dans l'une quelconque des revendications 1 à 7.

**9.** Procédé de production d'une composition pour dispositif électroluminescent contenant un matériau hôte et un

matériau invité mélangés dans celle-ci, comprenant

une étape de préparation de matériau hôte consistant à préparer un matériau hôte contenant un composé aromatique présentant un squelette de cycle condensé dans lequel seuls au moins trois cycles benzène sont condensés,
une étape de préparation de matériau invité consistant à préparer un matériau invité contenant un composé présentant un groupe hétérocyclique contenant un atome de carbone et au moins un élément choisi dans le groupe constitué d'un atome de bore, d'un atome d'azote, d'un atome de phosphore, d'un atome d'oxygène, d'un atome de soufre et d'un atome de sélénium dans le cycle, et
une étape de production consistant à mélanger ledit matériau hôte et ledit matériau invité selon un rapport de mélange tel que la quantité totale d'atomes de silicium contenus dans ledit matériau hôte et d'atomes de silicium contenus dans ledit matériau invité est supérieure ou égale à 7 ppm en masse et inférieure ou égale à 28 ppm en masse afin d'obtenir une composition pour dispositif électroluminescent ; et

(a) ledit composé aromatique présentant un squelette de cycle condensé dans lequel seuls au moins trois cycles benzène sont condensés est un composé représenté par la formule (FH) :

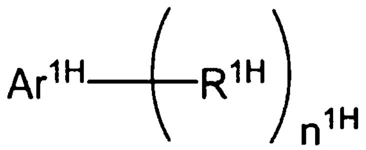

(FH)

où,

$n^{1H}$ représente un nombre entier égal ou supérieur à 0,
$Ar^{1H}$ représente un groupe obtenu par élimination à partir d'un hydrocarbure aromatique présentant un squelette de cycle condensé dans lequel seuls au moins trois cycles benzène sont condensés, d'au moins $n^{1H}$ atomes d'hydrogène liés directement à des atomes de carbone constituant ledit squelette de cycle condensé, et ce groupe présente éventuellement un substituant, lorsqu'une pluralité de substituants sont présents, ils peuvent être identiques ou différents et peuvent être combinés ensemble pour former un cycle conjointement avec des atomes auxquels ils sont attachés,
$R^{1H}$ représente un groupe aryle ou un groupe hétérocyclique monovalent, et ces groupes présentent éventuellement un substituant, lorsqu'une pluralité de substituants sont présents, ils peuvent être identiques ou différents et peuvent être combinés ensemble pour former un cycle conjointement avec des atomes auxquels ils sont attachés, lorsqu'une pluralité de $R^{1H}$ sont présents, ils peuvent être identiques ou différents et peuvent être combinés ensemble pour former un cycle conjointement avec des atomes auxquels ils sont attachés ; et

(b) ledit composé présentant le groupe hétérocyclique est un composé représenté par la formule (FB) :

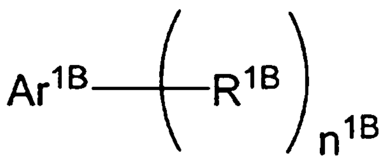

(FB)

où,

$n^{1B}$ représente un nombre entier égal ou supérieur à 0.
$Ar^{1B}$ représente un groupe obtenu par élimination à partir d'un composé présentant un cycle hétérocyclique contenant un atome de carbone et au moins un atome choisi dans le groupe constitué d'un atome de bore, d'un atome d'azote, d'un atome de phosphore, d'un atome d'oxygène, d'un atome de soufre et d'un atome de sélénium dans le cycle d'au moins $n^{1B}$ atomes d'hydrogène liés directement à des atomes constituant le cycle hétérocyclique décrit ci-dessus, et ce groupe présente éventuellement un substituant, lorsqu'une pluralité de substituants sont présents, ils peuvent être identiques ou différents et peuvent être combinés ensemble pour former un cycle conjointement avec des atomes auxquels ils sont

attachés.

$R^{1B}$ représente un atome d'halogène, un groupe alkyle, un groupe cycloalkyle, un groupe alcoxy, un groupe cycloalcoxy, un groupe aryloxy, un groupe aryle, un groupe hétérocyclique monovalent ou un groupe amino substitué, et ces groupes présentent éventuellement un substituant, lorsqu'une pluralité de substituants sont présents, ils peuvent être identiques ou différents et peuvent être combinés ensemble pour former un cycle conjointement avec des atomes auxquels ils sont attachés, lorsqu'une pluralité de $R^{1B}$ sont présents, ils peuvent être identiques ou différents et peuvent être combinés ensemble pour former un cycle conjointement avec des atomes auxquels ils sont attachés.

**10.** Procédé de production selon la revendication 9, dans lequel ladite étape de préparation de matériau hôte comprend

une étape (A-1) consistant à préparer ledit composé aromatique présentant un squelette de cycle condensé dans lequel seuls au moins trois cycles benzène sont condensés contenant des atomes de silicium mélangés à celui-ci, et

une étape (A-2) consistant à purifier au moins une partie dudit composé aromatique présentant un squelette de cycle condensé dans lequel seuls au moins trois cycles benzène sont condensés, préparé dans ladite étape (A-1), afin d'éliminer au moins une partie desdits atomes de silicium.

**11.** Procédé de production selon la revendication 9 ou 10, dans lequel ladite étape de préparation de matériau invité comprend

une étape de préparation (B-1) consistant à préparer ledit composé présentant le groupe hétérocyclique contenant des atomes de silicium mélangés à celui-ci, et

une étape (B-2) consistant à purifier au moins une partie dudit composé présentant le groupe hétérocyclique préparé dans ladite étape (B-1) afin d'éliminer au moins une partie desdits atomes de silicium.

**12.** Procédé de production d'une composition pour dispositif électroluminescent contenant un matériau hôte et un matériau invité mélangés dans celle-ci, comprenant :

(a) une étape de préparation de matériau hôte consistant à préparer un matériau hôte contenant un composé aromatique présentant un squelette de cycle condensé dans lequel seuls au moins trois cycles benzène sont condensés,

une étape de détermination consistant à déterminer le rapport de mélange entre matériau invité et ledit matériau hôte,

une étape de préparation de matériau invité consistant à préparer un matériau invité qui contient un composé présentant un groupe hétérocyclique contenant un atome de carbone et au moins un atome choisi dans le groupe constitué d'un atome de bore, d'un atome d'azote, d'un atome de phosphore, d'un atome d'oxygène, d'un atome de soufre et d'un atome de sélénium dans le cycle et avec lequel, lorsqu'il est mélangé avec ledit matériau hôte selon ledit rapport de mélange, la quantité totale d'atomes de silicium contenus dans ledit matériau hôte et d'atomes de silicium contenus dans ledit matériau invité par rapport à la quantité totale dudit matériau hôte et dudit matériau invité est supérieure ou égale à 7 ppm en masse et inférieure ou égale à 28 ppm en masse, et

une étape de production consistant à mélanger ledit matériau hôte et ledit matériau invité selon ledit rapport de mélange afin d'obtenir une composition pour dispositif électroluminescent ; ou

(b) une étape de préparation de matériau invité consistant à préparer un matériau invité contenant un composé présentant un groupe hétérocyclique contenant un atome de carbone et au moins un élément choisi dans le groupe constitué d'un atome de bore, d'un atome d'azote, d'un atome de phosphore, d'un atome d'oxygène, d'un atome de soufre et d'un atome de sélénium dans le cycle,

une étape de détermination consistant à déterminer le rapport de mélange entre le matériau hôte et ledit matériau invité,

une étape de préparation de matériau hôte consistant à préparer un matériau hôte qui contient un composé aromatique présentant un squelette de cycle condensé dans lequel seuls au moins trois cycles benzène sont condensés et avec lequel, lorsqu'il est mélangé avec ledit matériau hôte selon ledit rapport de mélange, la quantité totale d'atomes de silicium contenus dans ledit matériau hôte et d'atomes de silicium contenus dans

ledit matériau invité par rapport à la quantité totale dudit matériau hôte et dudit matériau invité est supérieure ou égale à 7 ppm en masse et inférieure ou égale à 28 ppm en masse, et

une étape de production consistant à mélanger ledit matériau invité et ledit matériau hôte selon ledit rapport de mélange afin d'obtenir une composition pour dispositif électroluminescent ; ou

(c) une étape de préparation de matériau hôte consistant à préparer un composé aromatique présentant un squelette de cycle condensé dans lequel seuls au moins trois cycles benzène sont condensés en tant que matériau hôte,

une étape de préparation de matériau invité consistant à préparer un matériau invité contenant un composé présentant un groupe hétérocyclique contenant un atome de carbone et au moins un élément choisi dans le groupe constitué d'un atome de bore, d'un atome d'azote, d'un atome de phosphore, d'un atome d'oxygène, d'un atome de soufre et d'un atome de sélénium dans le cycle, en tant que matériau invité,

une étape de détermination consistant à déterminer le rapport de mélange dudit matériau hôte et dudit matériau invité,

une étape de purification consistant à purifier au moins une partie dudit composé aromatique présentant un squelette de cycle condensé dans lequel seuls au moins trois cycles benzène sont condensés et dudit composé présentant le groupe hétérocyclique de sorte que, lorsque ledit matériau hôte et ledit matériau invité sont mélangés selon ledit rapport de mélange, la quantité totale d'atomes de silicium contenus dans ledit matériau hôte et d'atomes de silicium contenus dans ledit matériau invité par rapport à la quantité totale dudit matériau hôte et dudit matériau invité est supérieure ou égale à 7 ppm en masse et inférieure ou égale à 28 ppm en masse, et

une étape de production consistant à mélanger ledit matériau hôte contenant ledit composé aromatique présentant un squelette de cycle condensé dans lequel seuls au moins trois cycles benzène sont condensés et ledit matériau invité contenant ledit composé présentant le groupe hétérocyclique selon ledit rapport de mélange afin d'obtenir une composition pour dispositif électroluminescent ; dans lequel, pour chacun des points (a) à (c) ci-dessus, (i) ledit composé aromatique présentant un squelette de cycle condensé dans lequel seuls au moins trois cycles benzène sont condensés est un composé représenté par la formule (FH) :

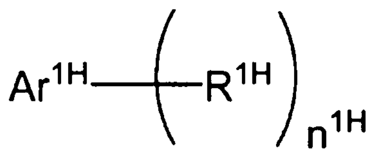
(FH)

où,

$n^{1H}$ représente un nombre entier égal ou supérieur à 0,

$Ar^{1H}$ représente un groupe obtenu par élimination à partir d'un hydrocarbure aromatique présentant un squelette de cycle condensé dans lequel seuls au moins trois cycles benzène sont condensés, d'au moins $n^{1H}$ atomes d'hydrogène liés directement à des atomes de carbone constituant ledit squelette de cycle condensé, et ce groupe présente éventuellement un substituant, lorsqu'une pluralité de substituants sont présents, ils peuvent être identiques ou différents et peuvent être combinés ensemble pour former un cycle conjointement avec des atomes auxquels ils sont attachés,

$R^{1H}$ représente un groupe aryle ou un groupe hétérocyclique monovalent, et ces groupes présentent éventuellement un substituant, lorsqu'une pluralité de substituants sont présents, ils peuvent être identiques ou différents et peuvent être combinés ensemble pour former un cycle conjointement avec des atomes auxquels ils sont attachés, lorsqu'une pluralité de $R^{1H}$ sont présents, ils peuvent être identiques ou différents et peuvent être combinés ensemble pour former un cycle conjointement avec des atomes auxquels ils sont attachés ; et

(ii) ledit composé présentant le groupe hétérocyclique est un composé représenté par la formule (FB) :

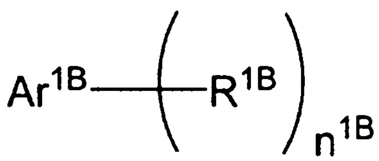
(FB)

où,

$n^{1B}$ représente un nombre entier égal ou supérieur à 0.
$Ar^{1B}$ représente un groupe obtenu par élimination à partir d'un composé présentant un cycle hétérocyclique contenant un atome de carbone et au moins un atome choisi dans le groupe constitué d'un atome de bore, d'un atome d'azote, d'un atome de phosphore, d'un atome d'oxygène, d'un atome de soufre et d'un atome de sélénium dans le cycle d'au moins $n^{1B}$ atomes d'hydrogène liés directement à des atomes constituant le cycle hétérocyclique décrit ci-dessus, et ce groupe présente éventuellement un substituant, lorsqu'une pluralité de substituants sont présents, ils peuvent être identiques ou différents et peuvent être combinés ensemble pour former un cycle conjointement avec des atomes auxquels ils sont attachés.
$R^{1B}$ représente un atome d'halogène, un groupe alkyle, un groupe cycloalkyle, un groupe alcoxy, un groupe cycloalcoxy, un groupe aryloxy, un groupe aryle, un groupe hétérocyclique monovalent ou un groupe amino substitué, et ces groupes présentent éventuellement un substituant, lorsqu'une pluralité de substituants sont présents, ils peuvent être identiques ou différents et peuvent être combinés ensemble pour former un cycle conjointement avec des atomes auxquels ils sont attachés, lorsqu'une pluralité de $R^{1B}$ sont présents, ils peuvent être identiques ou différents et peuvent être combinés ensemble pour former un cycle conjointement avec des atomes auxquels ils sont attachés.

**13.** Procédé de production selon l'une quelconque des revendications 9 à 12, comprenant en outre

une étape de mesure de matériau hôte consistant à mesurer la teneur en atomes de silicium contenus dans ledit composé aromatique présentant un squelette de cycle condensé dans lequel seuls au moins trois cycles benzène sont condensés, et
une étape de mesure de matériau invité consistant à mesurer la teneur en atomes de silicium contenus dans ledit composé présentant un groupe hétérocyclique contenant un atome de carbone et au moins un élément choisi dans le groupe constitué d'un atome de bore, d'un atome d'azote, d'un atome de phosphore, d'un atome d'oxygène, d'un atome de soufre et d'un atome de sélénium dans le cycle.

**14.** Procédé de production d'un dispositif électroluminescent contenant une anode, une cathode, et une couche organique disposée entre ladite anode et ladite cathode, comprenant
une étape consistant à former ladite couche organique avec la composition pour dispositif électroluminescent produite par le procédé de production décrit dans l'une quelconque des revendications 9 à 13.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2017183724 A
- EP 2301983 A
- US 2008113468 A
- JP 2011105643 A
- WO 2008056746 A
- WO 2014102543 A


### Non-patent literature cited in the description


- Experimental Chemistry Course. Maruzen, 1993
- Experimental Chemistry Course. Maruzen, 2007
- New Experimental Chemistry Course. Maruzen, 1975
- Guide to Organic Chemical Experiment. Kagaku-Dojin Publishing Company, Inc., 1988